# EUROPÄISCHE PATENTANMELDUNG

(11) **EP 0 949 312 A1**
(43) Veröffentlichungstag der Anmeldung: **13.10.1999**
(21) Anmeldenummer: 99104697.0
(22) Anmeldetag: 10.03.1999
(51) Int. Cl.: C09K 11/06, H05B 33/14

(54) **EL-Anordnung auf Basis von tert.-Aminen, in Alkohol löslichen Alq3-Derivaten bzw. Mischungen und polymeren Bindern**

(30) Priorität: 20.03.1998 DE 19812259
(71) Anmelder: BAYER AG, 51368 Leverkusen (DE)
(72) Erfinder: Koch, Friedrich Dr., 29664 Walsrode (DE); Heuer, Helmut Werner Dr., 47829 Krefeld (DE); Wehrmann, Rolf Dr., 47800 Krefeld (DE); Deussen, Martin Dr., 35039 Marburg (DE); Elschner, Andreas Dr., 45479 Mülheim (DE)

(57) **Zusammenfassung**

Elektrolumineszierende Anordnungen, enthaltend ein Substrat, eine Anode, ein elektrolumineszierendes Element und eine Kathode, wobei wenigstens eine der beiden Elektroden im sichtbaren Spektralbereich transparent ist und das elektrolumineszierende Element der Reihe nach enthalten kann: eine lochinjizierende Zone, lochtransportierende Zone, elektrolumineszierende Zone, elektronentransportierende Zone und/oder eine elektroneninjizierende Zone, dadurch gekennzeichnet, daß die lochinjizierende und lochtransportierende Zone eine gegebenenfalls substituierte Tris-1,3,5-(aminophenyl)benzolverbindung A oder eine Mischung davon ist und das elektrolumineszierende Element gegebenenfalls eine weitere funktionalisierte Verbindung aus der Gruppe der lochtransportierenden Materialien, ein lumineszierendes Material B und gegebenenfalls Elektronentransportmaterialien enthält, wobei die lochinjizierende und lochtransportierende Zone neben der Komponente A eine oder mehrere weitere lochtransportierende Verbindungen enthalten kann, wobei mindestens eine Zone vorhanden ist, einzelne Zonen weggelassen werden können und die vorhandene(n) Zone(n) mehrere Aufgaben übernehmen kann.

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-A 4 539 507, US-A 4 769 262, US-A 5 077 142, EP-A 406 762, EP-A 278 758, EP-A 278 757).

Weiterhin werden Polymere, wie Poly-(p-phenylene) und Poly-(p-phenylenvinylene (PPV)) als elektrolumineszierende Polymere beschrieben: G. Leising et al., Adv. Mater. 4 (1992) No. 1; Friend et al., J. Chem. Soc., Chem. Commun. 32 (1992); Saito et al., Polymer, 1990, Vol. 31, 1137; Friend et al., Physical Review B, Vol. 42, No. 18, 11670 oder WO-A 90/13148. Weitere Beispiele für PPV in Elektrolumineszenzanzeigen werden in EP-A 443 861, WO-A 92/03490 und WO-A 92/003491 beschrieben.

Zur Herstellung flexibler Polymer-LEDs haben Heeger at al. lösliche konjugierte PPV-Derivate vorgeschlagen (WO 92/16023).

Polymerblends unterschiedlicher Zusammensetzung sind ebenfalls bekannt: M. Stolka et al., Pure & Appt. Chem., Vol. 67, No. 1, pp 175-182, 1995; H. Bässler et al., Adv. Mater. 1995, 7, No. 6, 551; K. Nagai et al., Appl. Phys. Lett. 67 (16), 1995, 2281; EP-A 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
1 Träger, Substrat
2 Basiselektrode
3 Löcher-injizierende Schicht
4 Löcher-transportierende Schicht
5 Licht-emittierende Schicht
6 Elektronen-transportierende Schicht
7 Elektronen-injizierende Schicht
8 Topelektrode
9 Kontakte
10 Umhüllung, Verkapselung.

Die Schichten 3 bis 7 stellen das elektrolumineszierende Element dar.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO-A 90/13148 auf der Basis von Poly-(p-phenylenvinylen) beschrieben.

Der Aufbau von Mehrschichtsystemen kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings kann der Anlöseprozeß einer bereits aufgebrachten Schicht beim Überschichten mit der nächsten Schicht in bestimmten Fällen eine Schwierigkeit darstellen.

US-A 4 539 507 und US-A 5 150 006 beschreiben Metallkomplexe auf Basis von 8-Hydroxychinolin-Derivaten mit unterschiedlichen Zentralatomen, wie z.B. Zn, Al, Mg oder Li, die in einer Elektrolumineszenz-Anordnung als Emitter- und Elektroneninjektions- und transportschicht fungieren. Die beschriebenen Verbindungen zeigen jedoch nur eine geringe Löslichkeit in Alkoholen, so daß sie nur durch Aufdampfverfahren aufgebracht werden können. Beim Aufbringen dieser Verbindungen aus Lösungsmitteln wie z.B. THF, 1,2-Dichlorethan wurde die vorher aufgebrachte Lochleiterschicht angelöst bzw. der Lochleiter aus der Polymermatrix herausgelöst.

Die Aufgabe der vorliegenden Erfindung ist die Bereitstellung von elektrolumineszierenden Anordnungen mit hoher Leuchtdichte, wobei die aufzubringende Mischung gießbar aufgebracht werden kann. Die gilt sowohl für die lochinjizierende, lochtransportierende und elektrolumineszierende bzw. elektronentransportierende Schicht. Um beim Aufbringen der elektrolumineszierenden bzw. elektronentransportierenden Schicht nicht die darunterliegende Schicht anzulösen, müssen die zum Einsatz kommenden Verbindungen in Alkoholen, besonders aber in Methanol löslich sein. Dazu war es erforderlich, speziell substituierte Metallkomplexe zu synthetisieren, die in Methanol für den Gießprozeß eine ausreichende Löslichkeit aufweisen.

Es wurde gefunden, daß elektrolumineszierende Anordnungen, die untengenanntes Blendsystem sowie die erfindungsgemäßen in Alkoholen löslichen Emitter bzw. Elektronenleiter (Metallkomplexe) enthalten, diese Anforderungen erfüllen. Im folgenden ist der Begriff Zone auch mit Schicht gleichzusetzen.

Gegenstand der vorliegenden Erfindung sind daher elektrolumineszierende Anordnungen, enthaltend ein Substrat, eine Anode, ein elektrolumineszierendes Element und eine Kathode, wobei wenigstens eine der beiden Elektroden im sichtbaren Spektralbereich transparent ist und das elektrolumineszierende Element der Reihe nach enthalten kann:

Eine lochinjizierende Zone, lochtransportierende Zone, elektrolumineszierende Zone, elektronentransportierende Zone und/oder eine elektroneninjizierende Zone, dadurch gekennzeichnet, daß die lochinjizierende und/oder lochtransportierende Zone eine gegebenenfalls substituierte Tris-1,3,5-(aminophenyl)benzolverbindung A oder eine Mischung davon ist und das elektrolumineszierende Element gegebenenfalls eine weitere funktionalisierte Verbindung aus der Gruppe der lochtransportierenden Materialien, ein lumineszierendes Material B und gegebenenfalls Elektronentransportmaterialien enthält, wobei die lochinjizierende und lochtransportierende Zone neben der Komponente A eine oder mehrere weitere lochtransportierende Verbindungen enthalten kann, wobei mindestens eine Zone vorhanden ist, einzelne Zonen weggelassen werden können und die vorhandene(n) Zone(n) mehrere Aufgaben übernehmen kann.

Eine Zone kann mehrere Aufgaben übernehmen, d.h. daß eine Zone z.B. lochinjizierende, lochtransportierende, elektrolumineszierende, elektroneninjizierende und/oder elektronentransportierende Substanzen enthalten kann.

Das elektrolumineszierende Element kann ferner einen oder mehrere transparente polymere Binder C enthalten.

Die gegebenenfalls substituierte Tris-1,3,5-(aminophenyl)benzol-Verbindung A steht für eine aromatische tertiäre Aminoverbindung der allgemeinen Formel (I) 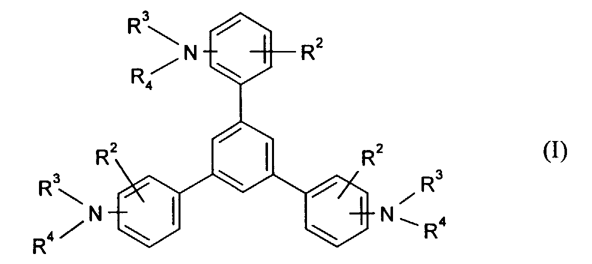 in welcher
- R²: für Wasserstoff, gegebenenfalls substituiertes Alkyl oder Halogen steht,
- R³ und R⁴: unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen.
- R³ und R⁴: stehen unabhängig voneinander bevorzugt für (C₁-C₆)-Alkyl, insbesondere Methyl, Ethyl, n- oder iso-Propyl, n-, iso-, sec.- oder tert.-Butyl, (C₁-C₄)-Alkoxcarbonyl-(C₁-C₆)-alkyl, wie beispielsweise Methoxy-, Ethoxy-, Propoxy-, Butoxycarbonyl-(C₁-C₄)-alkyl, jeweils gegebenenfalls durch (C₁-C₄)-Alkyl und/oder (C₁-C₄)-Alkoxy substituiertes Phenyl-(C₁-C₄)-alkyl, Naphthyl-(C₁-C₄)-alkyl, Cyclopentyl, Cyclohexyl, Phenyl oder Naphthyl.

Besonders bevorzugt stehen R³ und R⁴ unabhängig voneinander für unsubstituiertes Phenyl oder Naphthyl oder jeweils einfach bis dreifach durch Methyl, Ethyl, n-, iso-Propyl, Methoxy, Ethoxy, n- und/oder iso-Propoxy substituiertes Phenyl oder Naphthyl.

R² steht vorzugsweise für Wasserstoff, (C₁-C₆)-Alkyl, wie beispielsweise Methyl, Ethyl, n- oder iso-Propyl, n-, iso-, sec.- oder tert.-Butyl, oder Chlor.

Derartige Verbindungen und deren Herstellung sind in US-A 4 923 774 für den Einsatz in der Elektrophotographie beschrieben, welche hiermit ausdrücklich als Bestandteil der Beschreibung aufgenommen wird ("incorporated by reference"). Die Tris-Nitrophenyl-Verbindung kann beispielsweise durch allgemein bekannte katalytische Hydrierung beispielweise in Gegenwart von Raney-Nickel in die Tris-aminophenyl-Verbindung überführt werden (Houben-Weyl 4/1C, 14-102, Ullmann (4) 13, 135-148). Die Aminoverbindung wird in allgemein bekannter Weise mit substituierten Halogenbenzolen umgesetzt.

Beispielhaft seien die folgenden Verbindungen genannt, wobei die Substitution am Phenylring sowohl in ortho, meta und/oder para zum Aminstickstoff erfolgen kann:

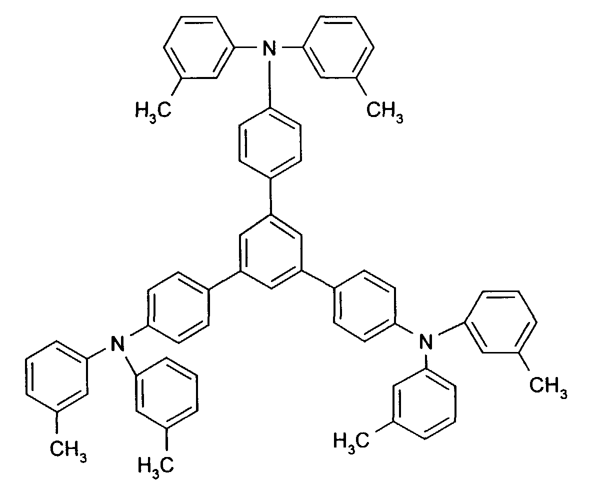

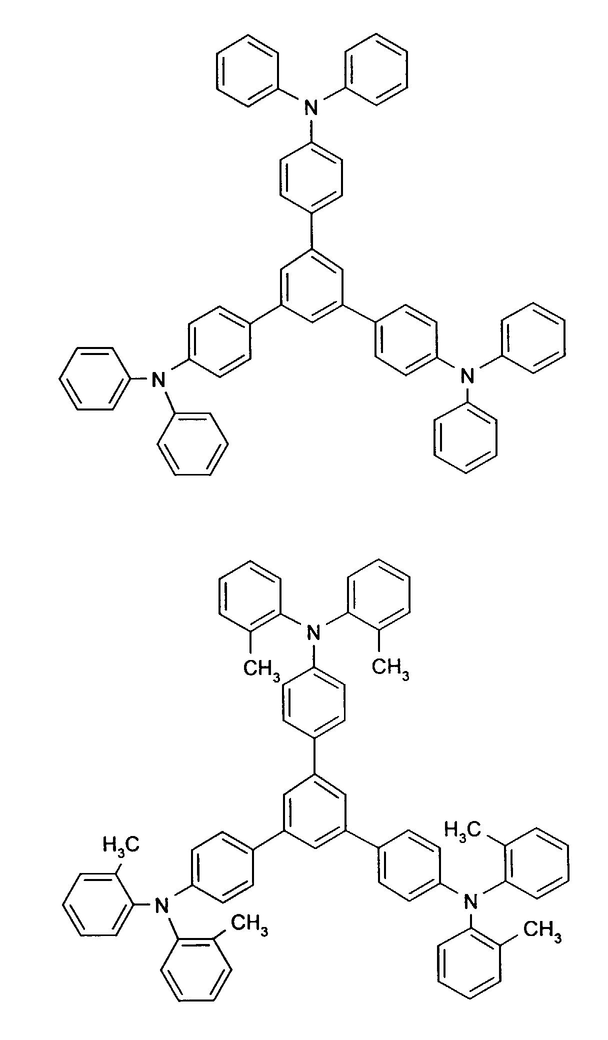

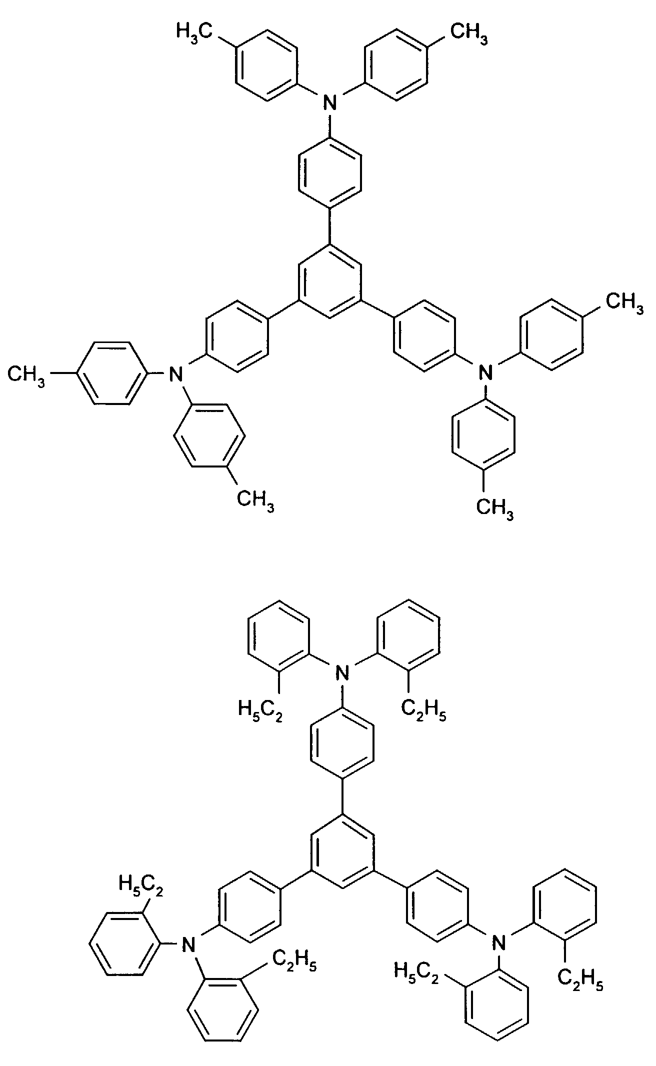

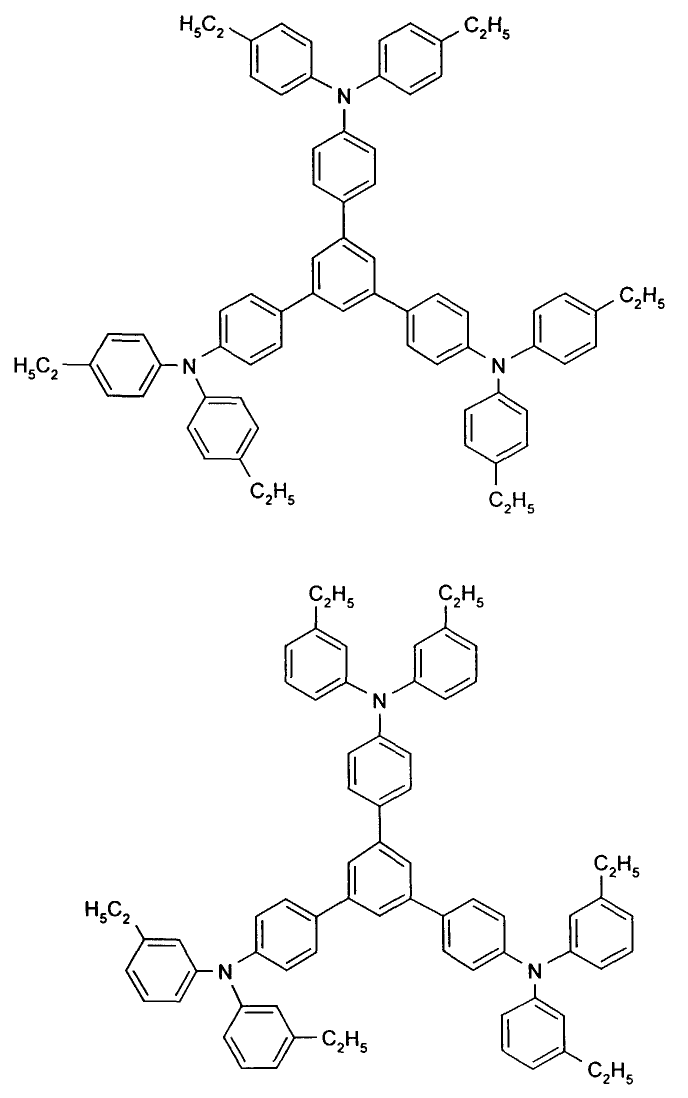

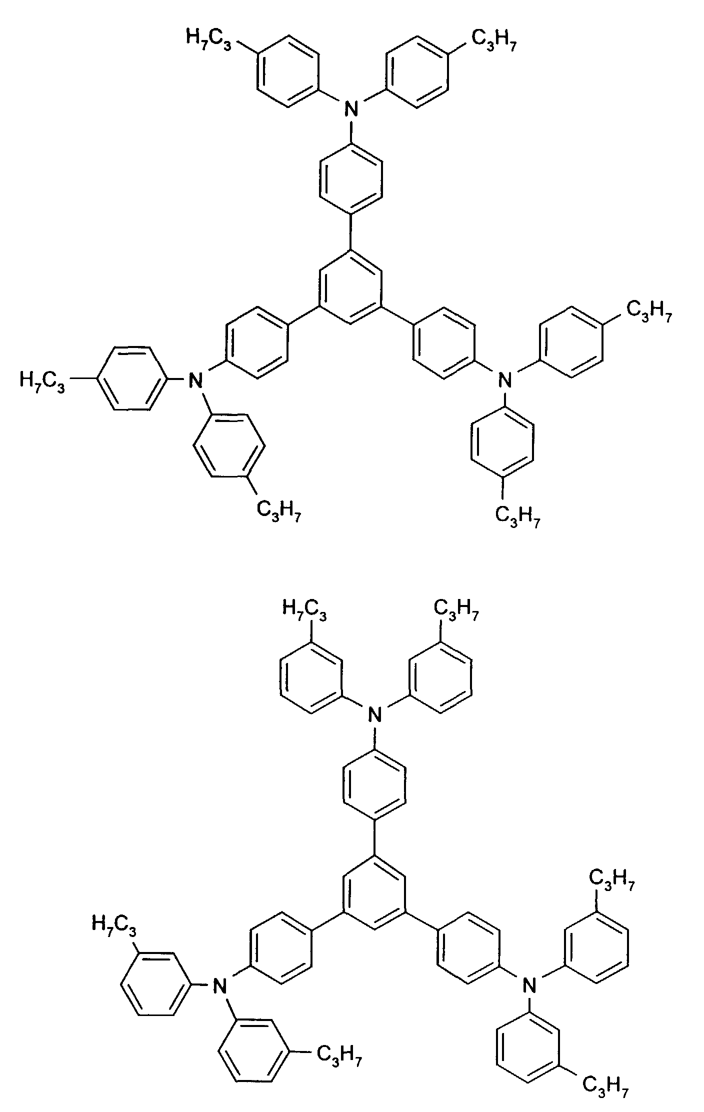

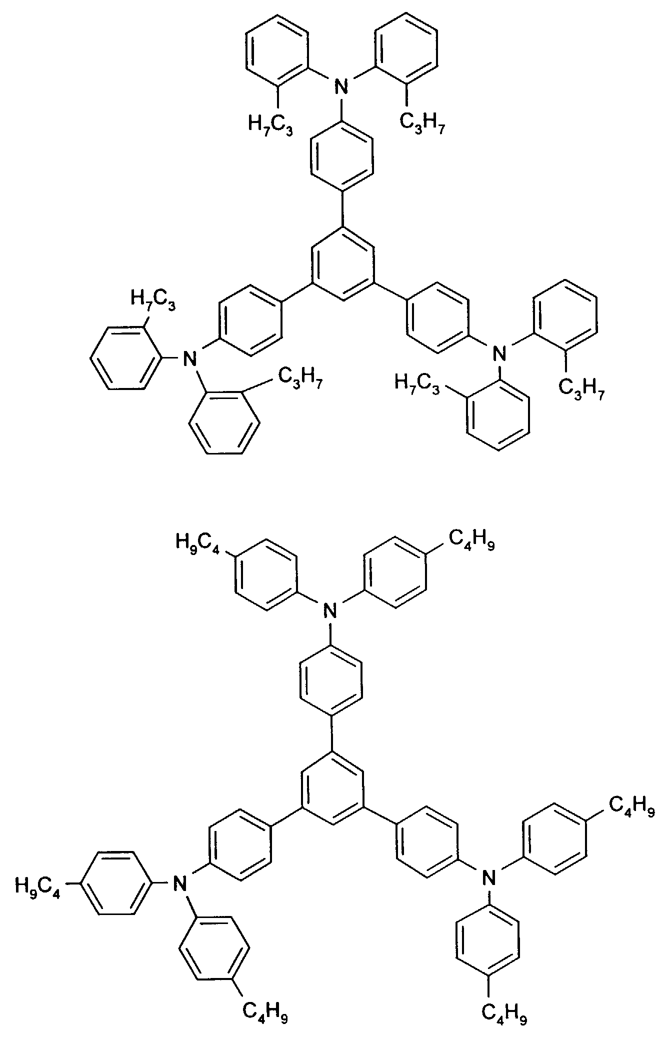

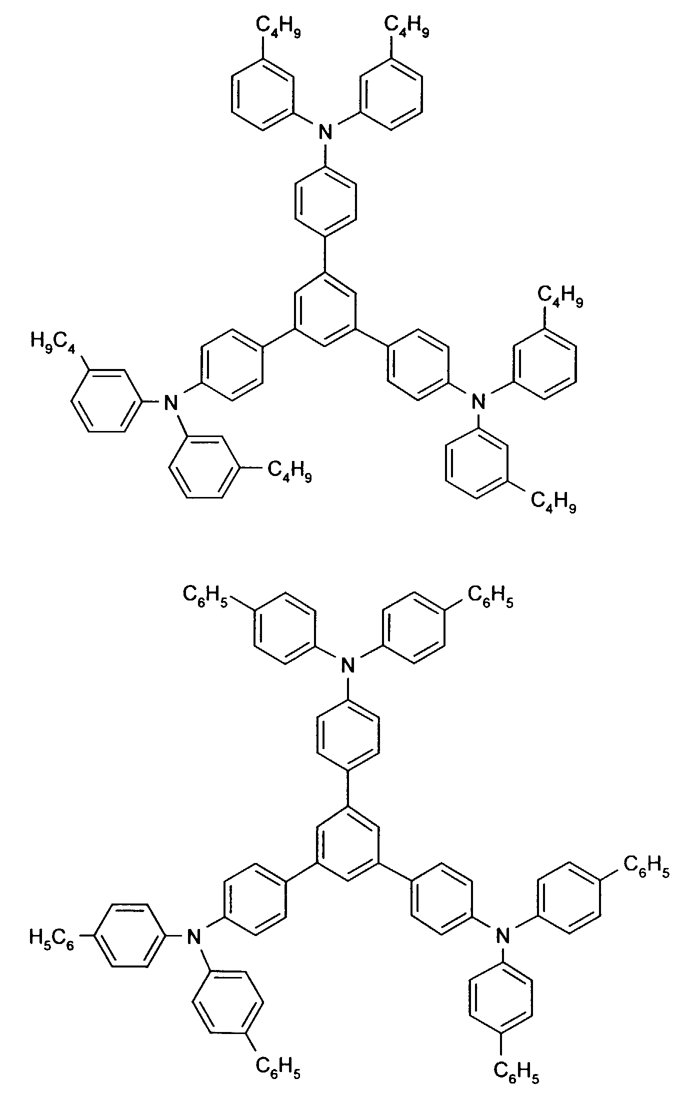

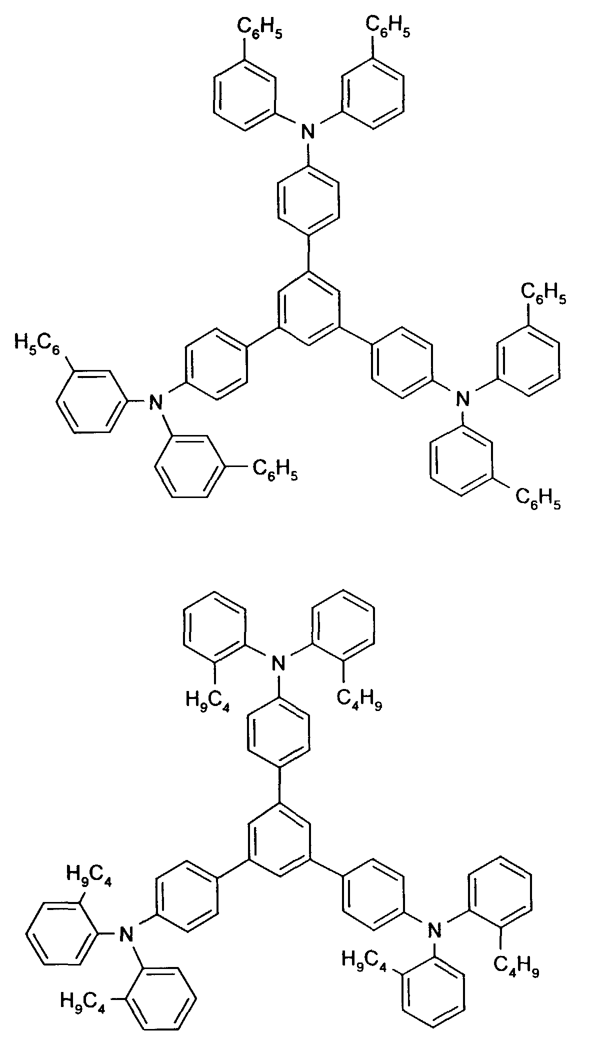

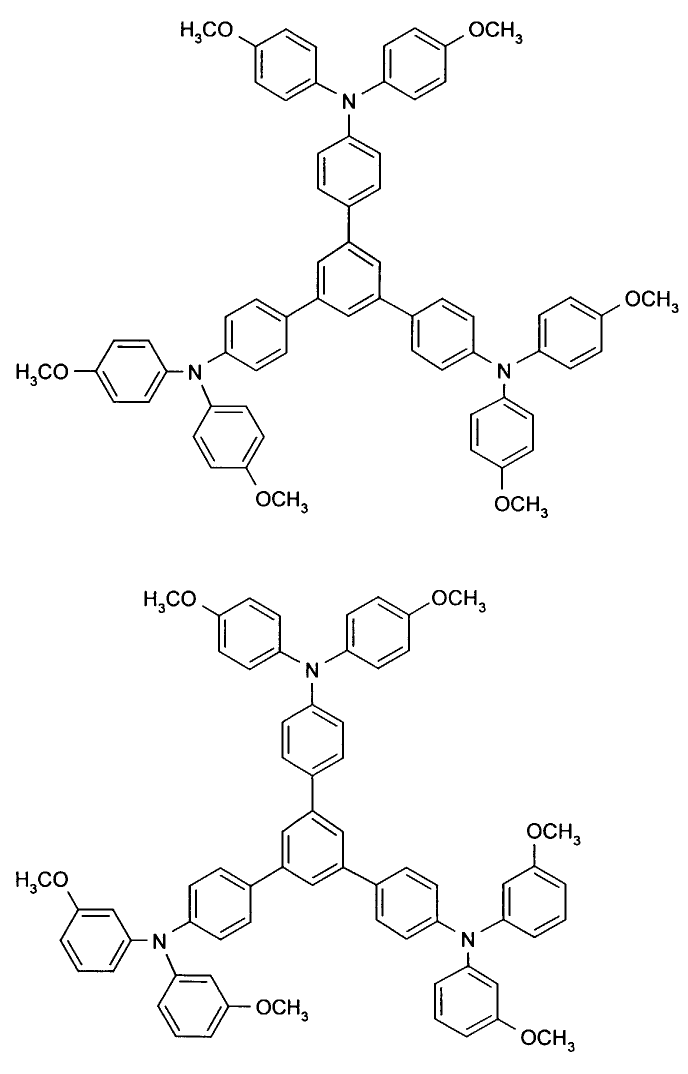

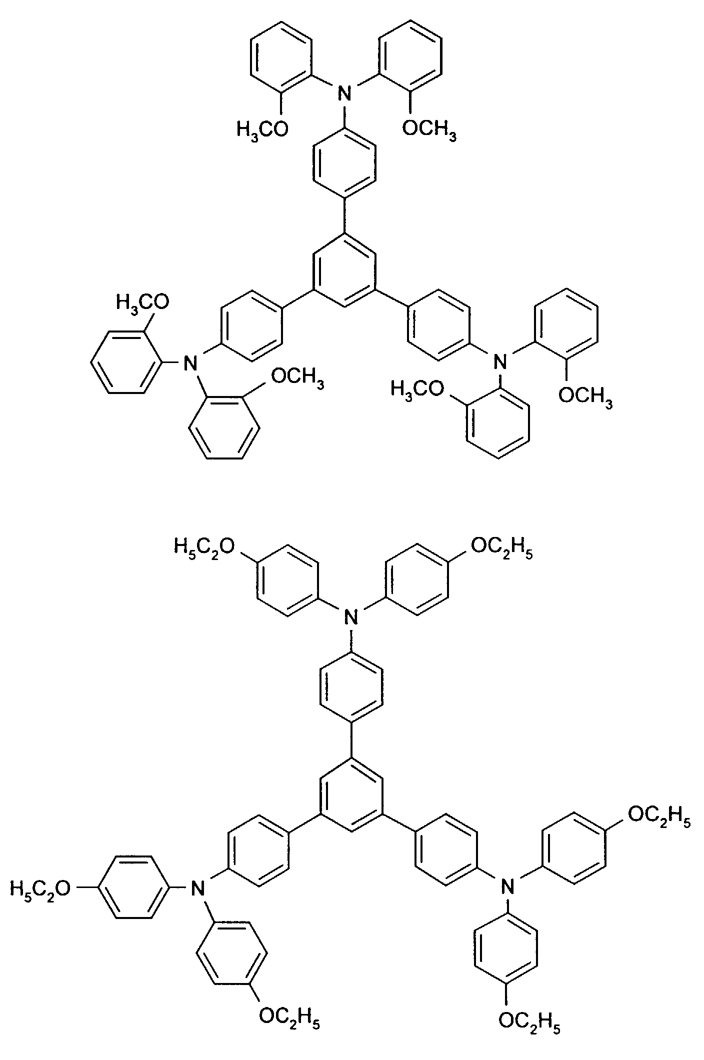

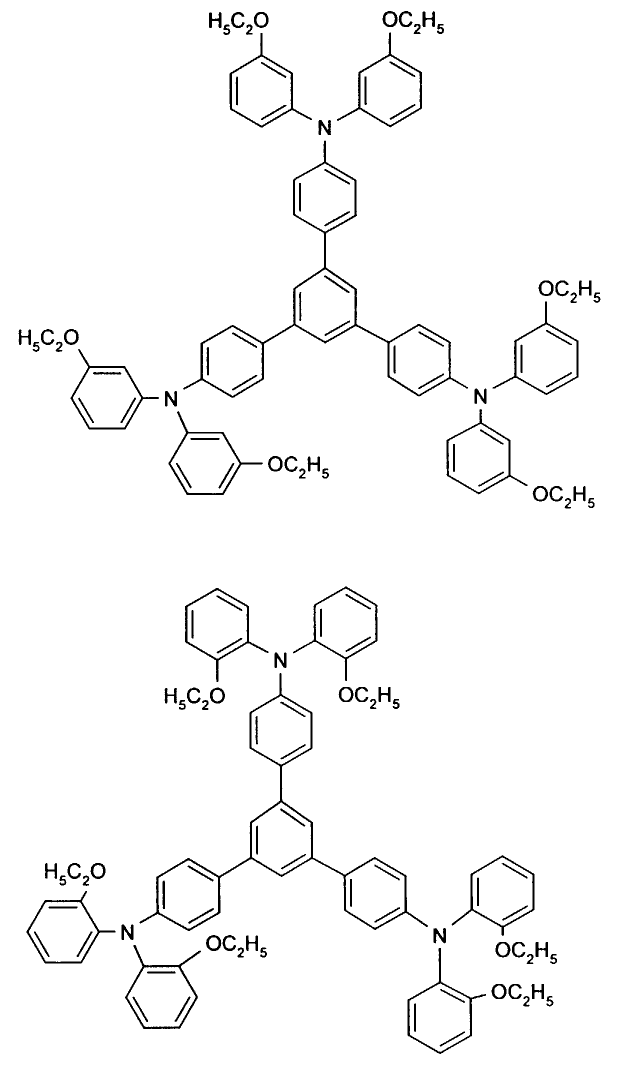

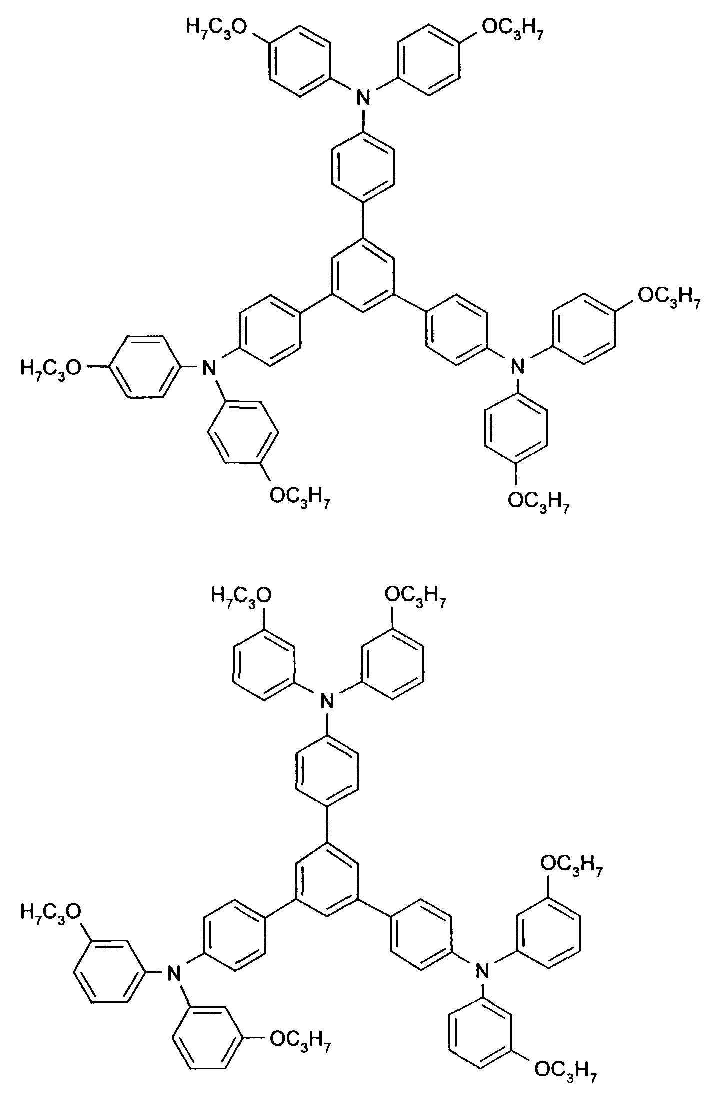

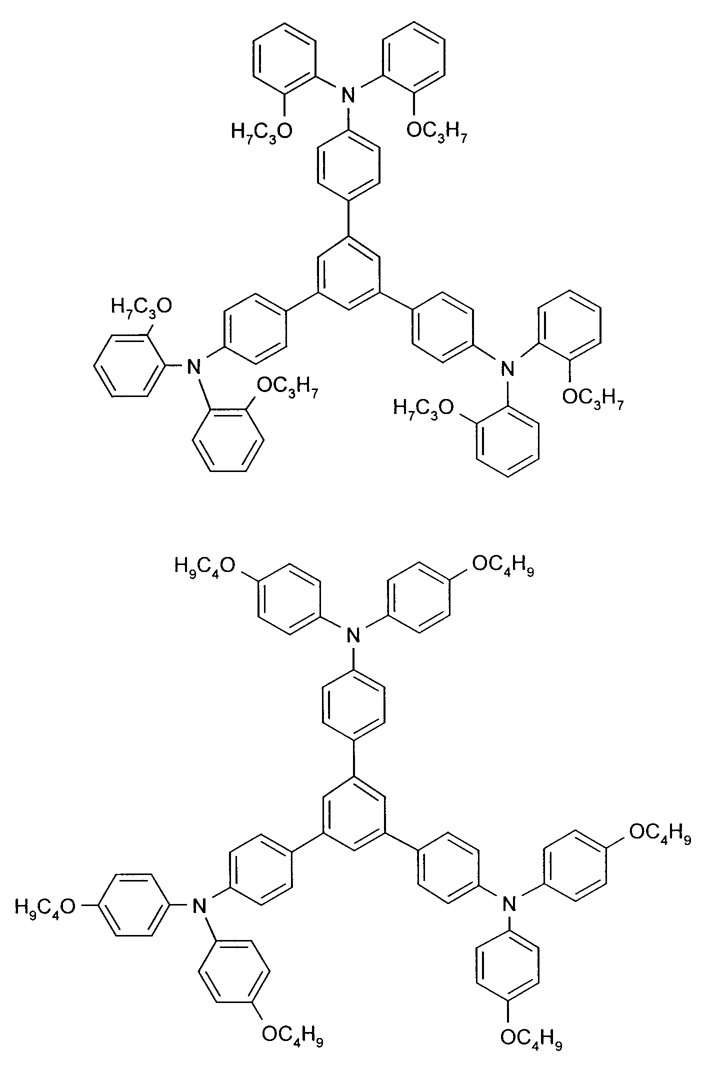

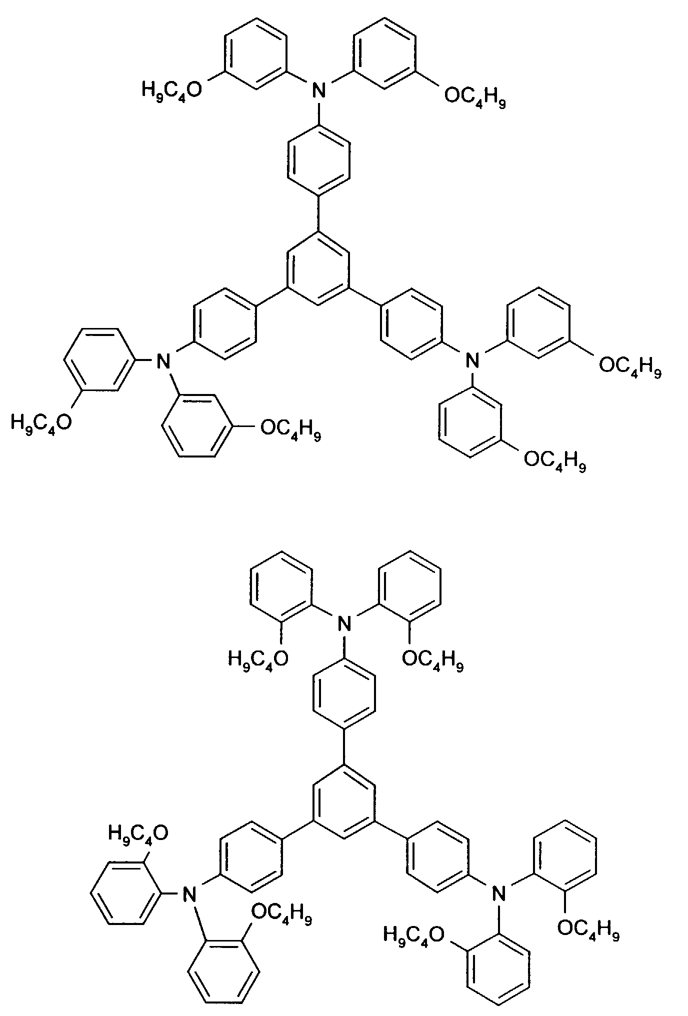

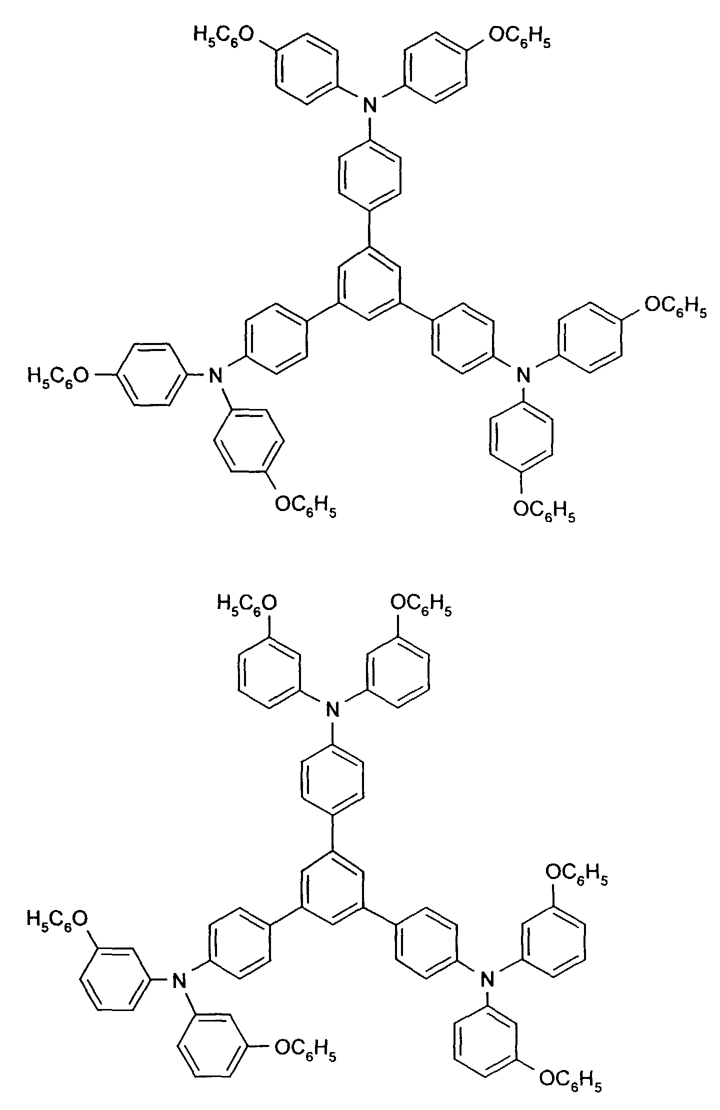

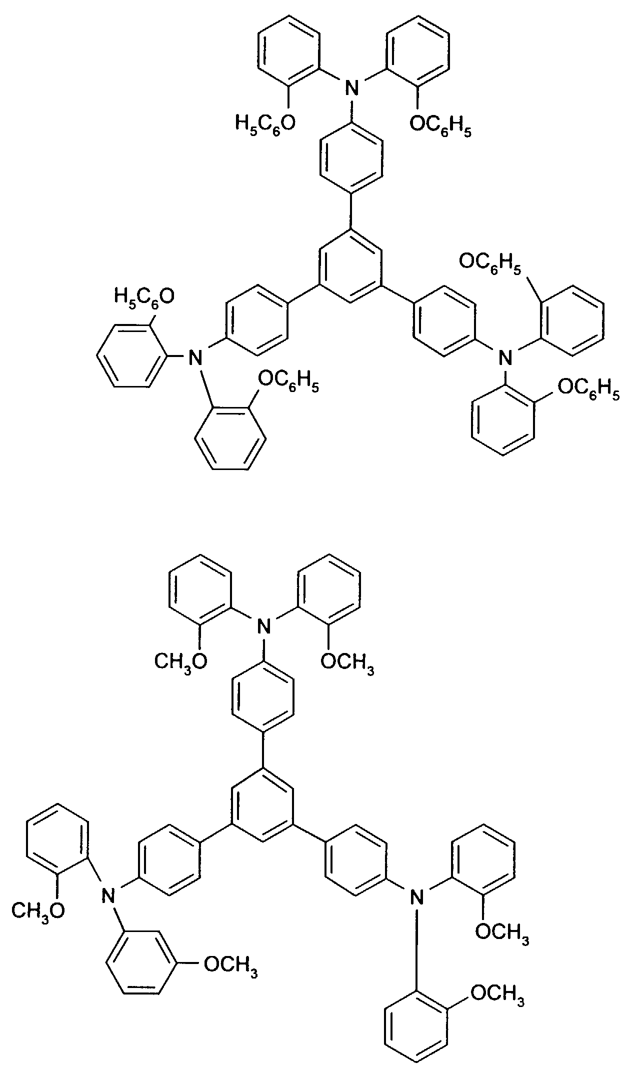

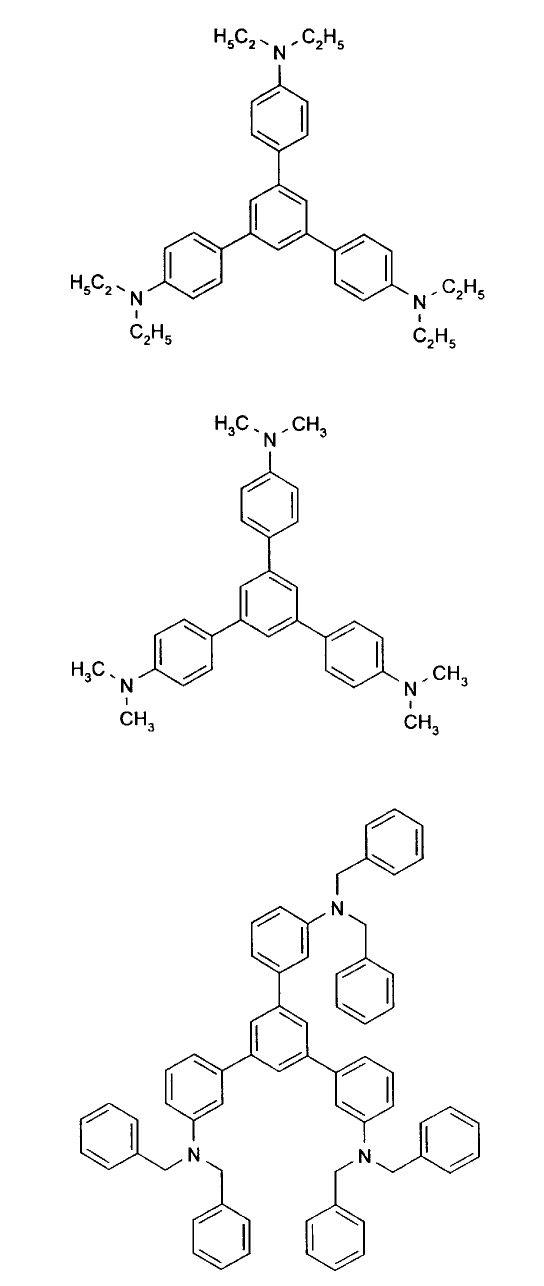

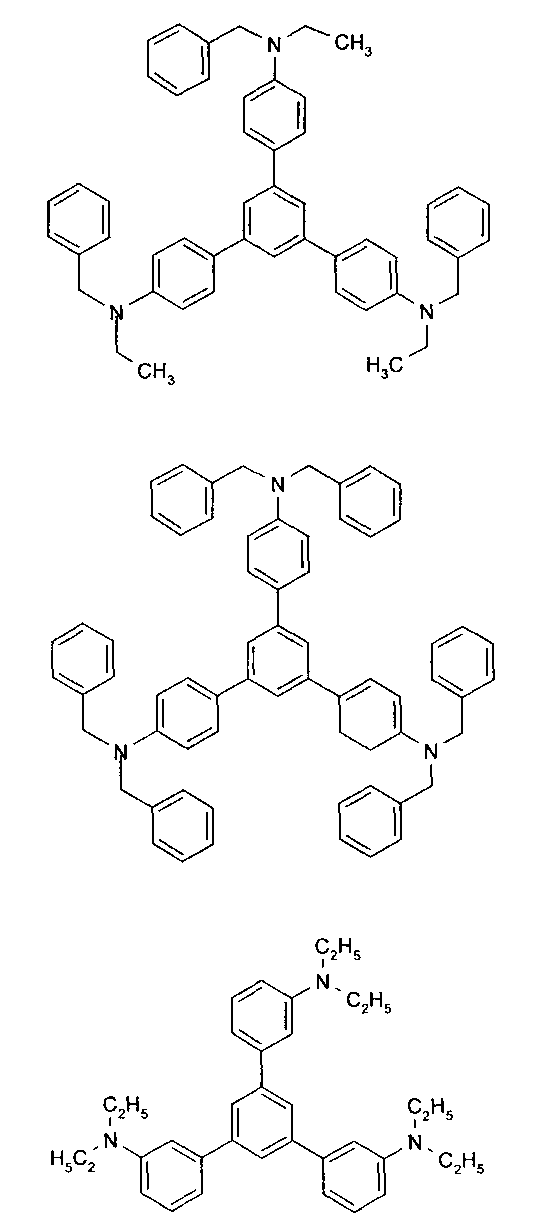

Neben der Komponente A können gegebenenfalls weitere Lochleiter, z.B. in Form einer Mischung mit der Komponente A, zum Aufbau des elektrolumineszierenden Elementes eingesetzt werden. Dabei kann es sich einerseits um eine oder mehrere Verbindungen der Formel (I), wobei auch Gemische von Isomeren umfaßt werden, andererseits auch um Mischungen von lochtransportierenden Verbindungen mit Verbindungen von A - mit der allgemeinen Formel (I) - mit verschiedener Struktur handeln.

Eine Zusammenstellung möglicher lochinjizierender und lochieitender Materialien ist in EP-A 532 798 angegeben.

Im Falle von Mischungen der Komponente A) können die Verbindungen in einem beliebigen Verhältnis zwischen 0 und 100 Gew.-% (bezogen auf die Mischung A)) eingesetzt werden. In einer bevorzugten Ausführungsform werden 1 bis 99 Gew.-% und 99 bis 1 Gew.-%, besonders bevorzugt 5 bis 95 Gew.-% und 95 bis 5 Gew.-% eingesetzt. In einer weiteren bevorzugten Ausführungsform werden 30 bis 70 Gew.-% bzw. 70 bis 30 Gew.-% eingesetzt.

Beispielhaft seien genannt:

Anthracen-Verbindungen, z.B. 2,6,9,10-Tetraisopropoxyanthracen; Oxadiazol-Verbindungen, z.B. 2,5-Bis(4-diethylaminophenyl)-1,3,4-oxadiazol, Triphenylamin-Verbindungen, z.B. N,N'-Diphenyl-N,N'-di(3-methylphenyl)-1,1'-biphenyl-4,4'-diamin; aromatische tertiäre Amine, z.B. N-Phenylcarbazol, N-Isopropyl-carbazol und Verbindungen, die in lochtransportierenden Schichten einsetzbar sind, wie sie in der japanischen Patentanmeldung JP-A 62-264 692 beschrieben sind; ferner Pyrazolin-Verbindungen, z.B. 1-Phenyl-3-(p-diethylaminostyryl)-5-(p-diethylaminophenyl)-2-pyrazolin; Styryl-Verbindungen, z.B. 9-(p-Diethylaminostyryl)-anthrazen; Hydrazon-Verbindungen, z.B. Bis-(4-dimethylamino-2-methylphenyl)-phenyl-methan; Stilben-Verbindungen, z.B. -(4-Methoxyphenyl)-4-N,N-diphenylamino-(4'-methoxy)stilben, Enamin-Verbindungen, z.B. 1,1-(4,4'-diethoxyphenyl)-N,N-(4,4'-dimethoxyphenyl)enamin; Metall- oder Nichtmetall-Phthalocyanine und Porphyrin-Verbindungen.

Bevorzugt sind Triphenylamin-Verbindungen und/oder aromatische tertiäre Amine, wobei die beispielhaft genannten Verbindungen besonders bevorzugt sind.

Materialien, die lochleitende Eigenschaften aufweisen und als Mischpartner zur Komponente A eingesetzt werden können, sind beispielsweise

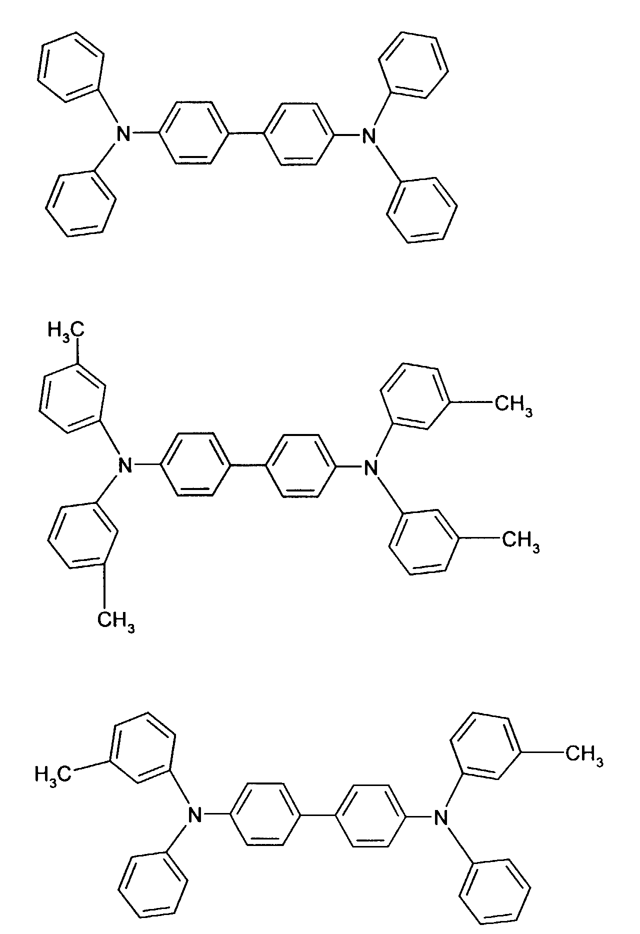

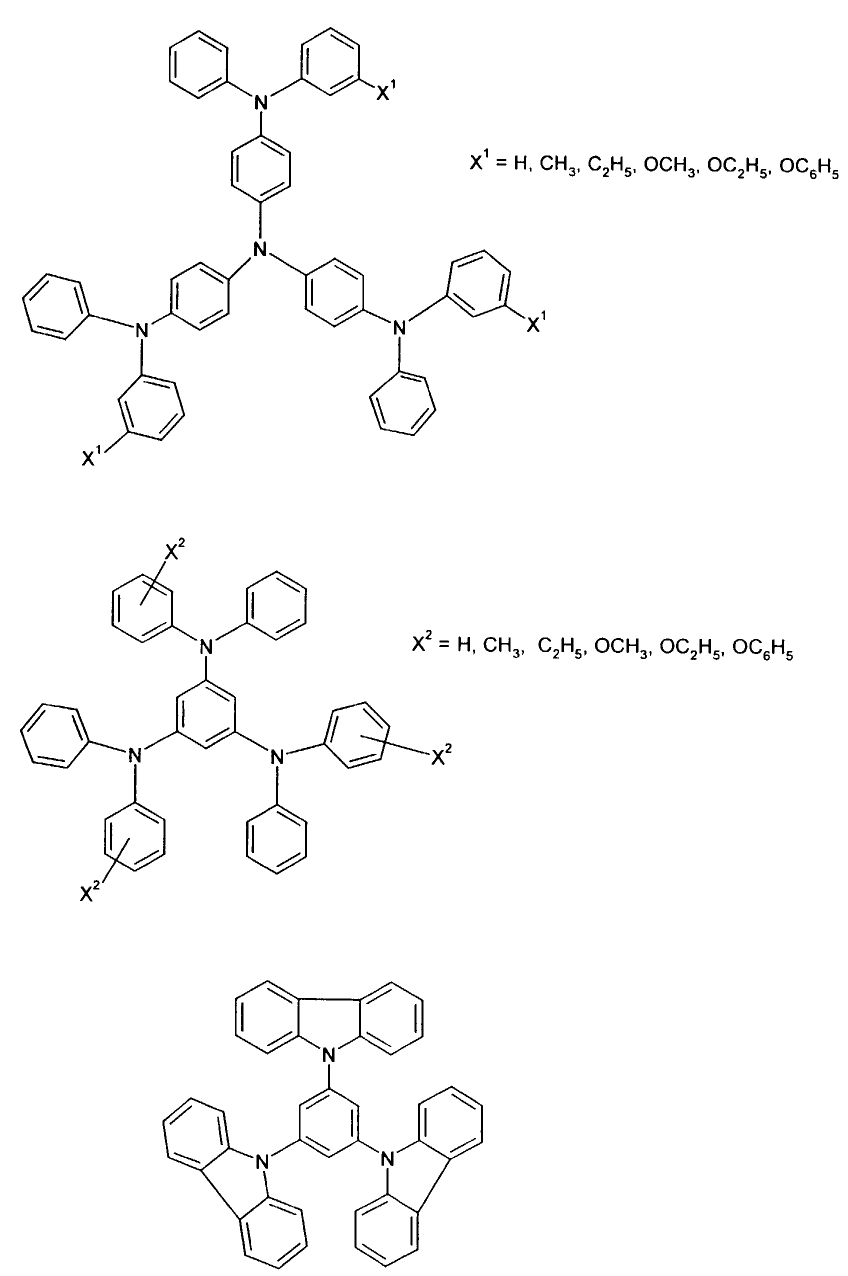

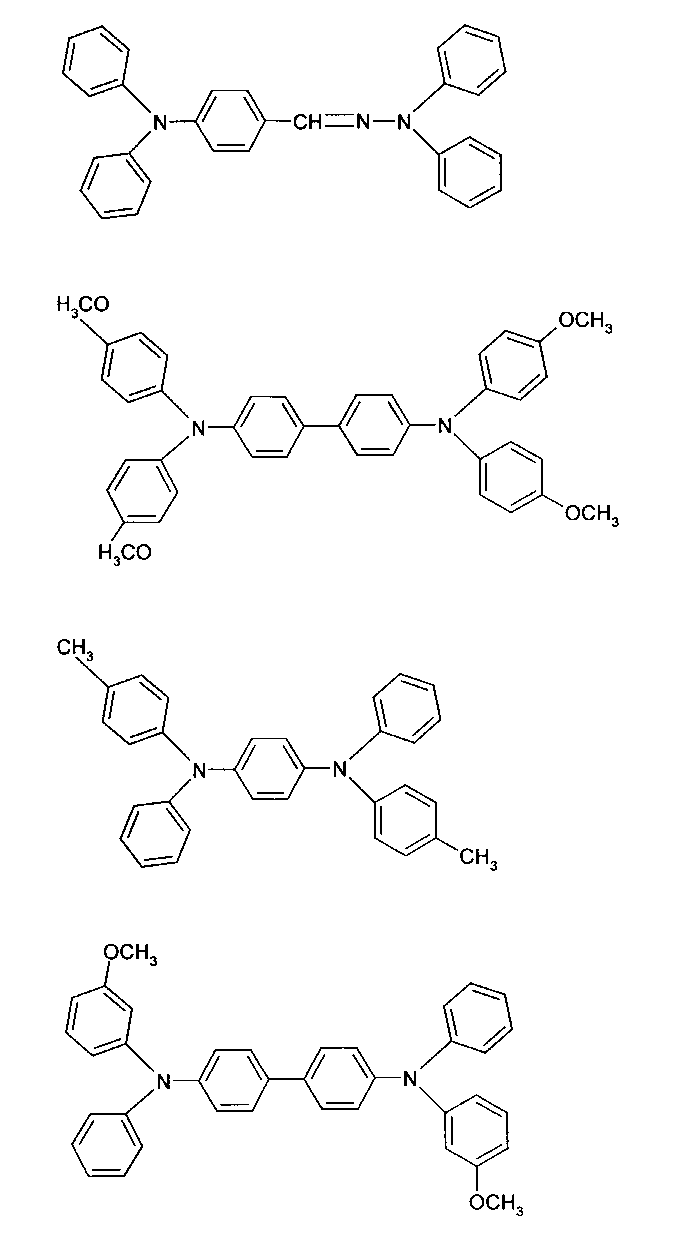

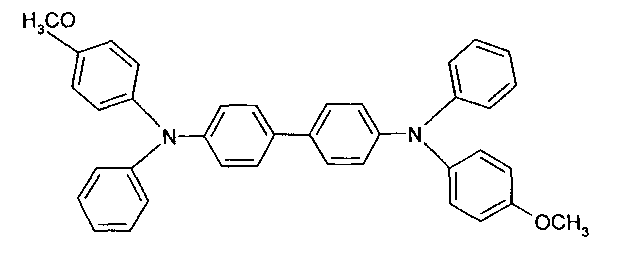

Diese und weitere Beispiele sind beschrieben in J. Phys. Chem. 1993, 97, 6240-6248 und Appl. Phys. Lett., Vol. 66, No. 20, 2679-2681.

Der Binder C) steht für Polymere und/oder Copolymere wie z.B. Polycarbonate, Polyestercarbonate, Copolymere des Styrols wie SAN oder Styrolacrylate, Polysulfone, Polymerisate auf Basis von Vinylgruppen-haltigen Monomeren wie z.B. Poly(meth)acrylate, Polyvinylpyrrolidon, Polyvinylcarbazol, Vinylacetat- und Vinylalkoholpolymere und -copolymere, Polyolefine, cyclische Olelfincopolymere, Phenoxyharze usw. Es können auch Mischungen verschiedener Polymere eingesetzt werden. Die polymeren Binder C) weisen vorzugsweise Molekulargewichte von 10 000 bis 2 000 00 g/mol auf, sind löslich und filmbildend und sind im sichtbaren Spektralbereich transparent. Sie sind z.B. beschrieben in Encyclopedia of Polymer Science and Engineering, 2^{nd} Ed. bei A. Wiley-Intersciencepublication. Sie werden üblicherweise in einer Menge bis zu 95, vorzugsweise bis zu 80 Gew.-%, bezogen auf das Gesamtgewicht aus A) und B), eingesetzt.

Die Komponente B) steht für eine Verbindung der allgemeinen Formel (II)

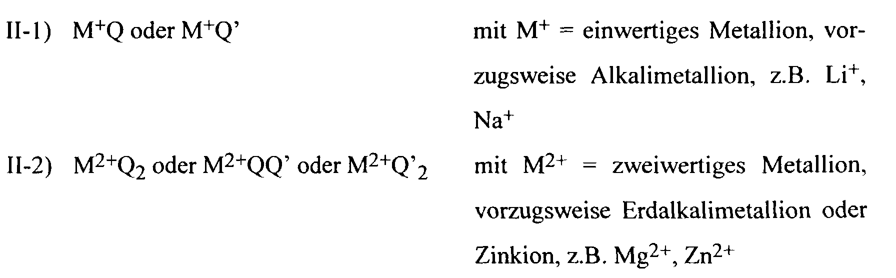

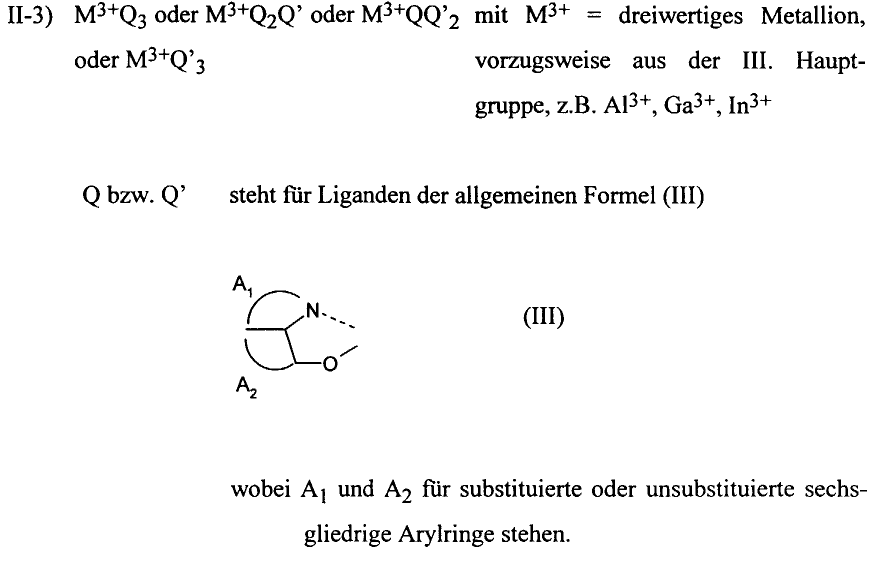

Bevorzugte Struktur von Q: 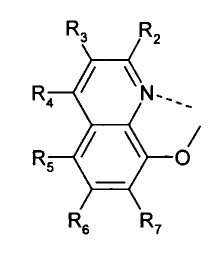 wobei
- R₃, R₄, R₆ =: Wasserstoff,
- R₂ =: Wasserstoff oder jeweils gegebenenfalls substituiertes Alkyl, Aryl, Cycloalkyl, Heteroaryl, vorzugsweise Wasserstoff oder jeweils gegebenenfalls substituiertes (C₁-C₁₂)-Alkyl, Cyclohexyl, Cyclopentyl, Phenyl, Naphthyl, Heteroaryl mit 6 bis 12 C-Atomen und Stickstoff, Sauerstoff und/oder Schwefel als Heteroatom(e)
- R₅ oder R₇ =: jeweils gegebenenfalls substituiertes Alkanoyl, vorzugsweise mit 1 bis 20 Kohlenwasserstoffatomen, Cycloalkanoyl, vorzugsweise mit 4 bis 8, insbesondere 5 oder 6 C-Atomen, Aryloyl, vorzugsweise Benzoyl, Naphthoyl, oder Heteroaryloxy mit 6 bis 12 C-Atomen und Stickstoff, Sauerstoff und/oder Schwefel als Heteroatome, und der jeweils andere Rest R⁷ oder R⁵ dann für Wasserstoff steht,
- R₅: kann zusätzlich auch für Di(alkylamino) oder Di(cycloalkyl)amino oder Piperidylsulfamoyl stehen.

Bevorzugte Struktur von Q 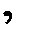 : 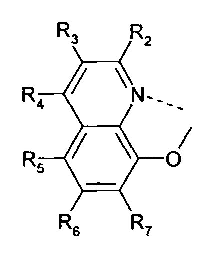
- R₂, R₃, R₄, R₅, R₆ =: Wasserstoff
- R₇ =: durch Halogen oder Cyano substituiertes oder unsubstituiertes (C₁-C₂₀)-Alkyl, das auch verzweigt sein kann durch Halogen oder Cyano substituiertes oder unsubstituiertes C₅- oder C₆-Cycloalkyl
durch Halogen oder Cyano substituiertes oder unsubstituiertes Phenyl oder Naphthyl
durch Halogen oder Cyano substituiertes oder unsubstituiertes Heteroaryl mit 6 bis 12 C-Atomen und Stickstoff, Sauerstoff und/oder Schwefel als Heteroatom.

Generell können ein-, zwei- oder dreiwertige Metalle benutzt werden, von denen bekannt ist, daß sie Chelate bilden.
II-4) Mischung aus den Vertretern von II-1), II-2) und II-30) in beliebiger Konzentration mit und ohne Polymerbinder

Als Beispiele für derartige Verbindungen seien genannt

### Beispiel 1

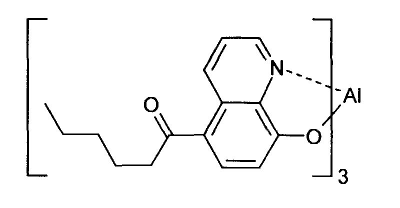

### Beispiel 2

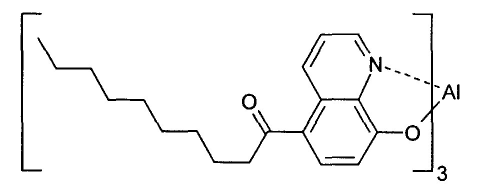

### Beispiel 3

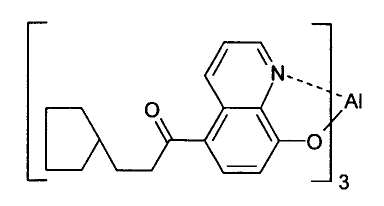

### Beispiel 4

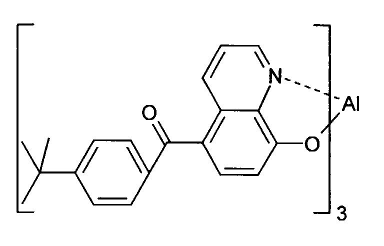

### Beispiel 5

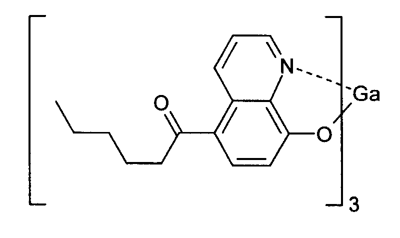

### Beispiel 6

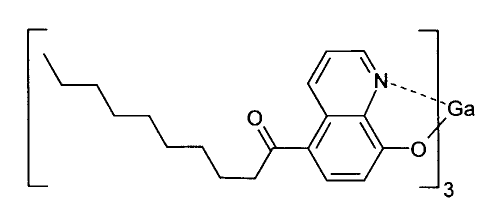

### Beispiel 7

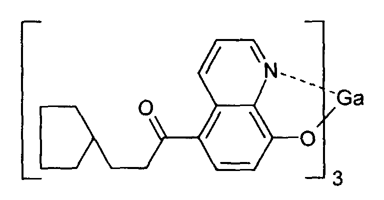

### Beispiel 8

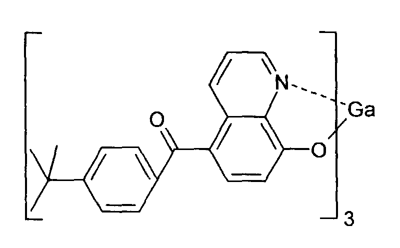

### Beispiel 9

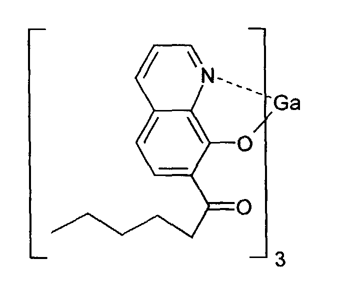

### Beispiel 10

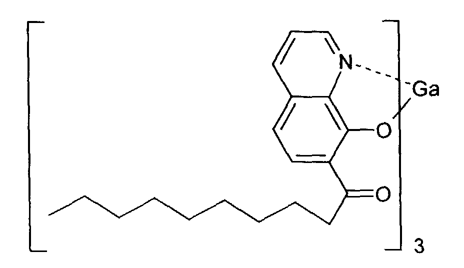

### Beispiel 11

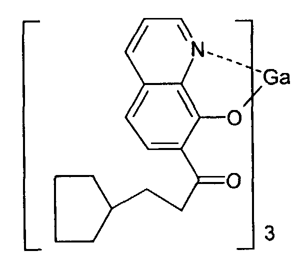

### Beispiel 12

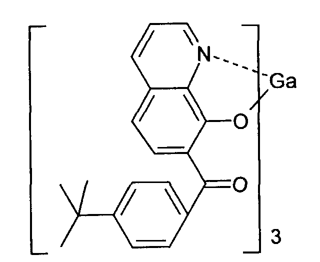

### Beispiel 13

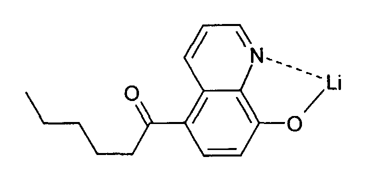

### Beispiel 14

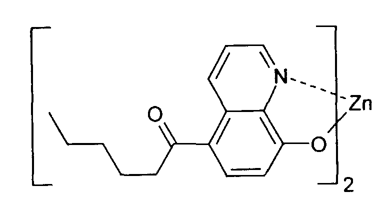

### Beispiel 15

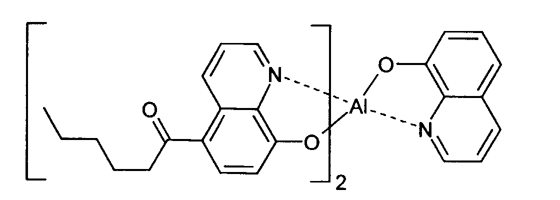

### Beispiel 16

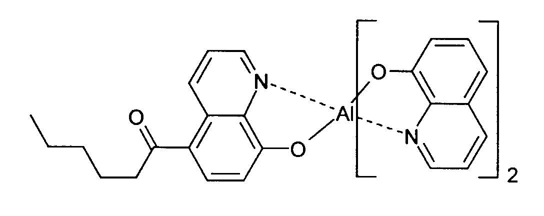

### Beispiel 17

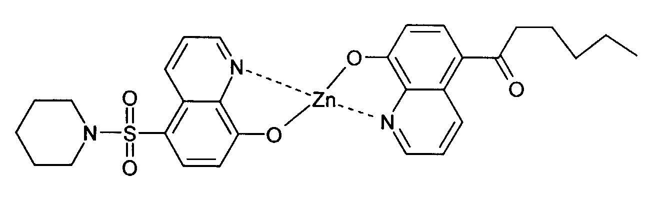

### Beispiel 18

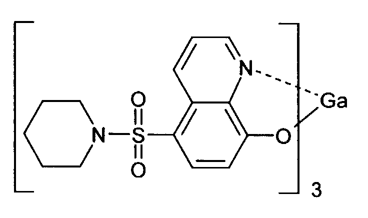

### Beispiel 19

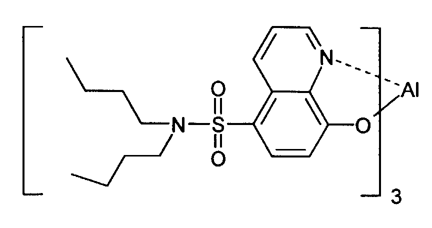

### Beispiel 20

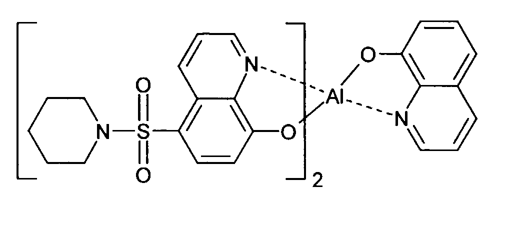

### Beispiel 21

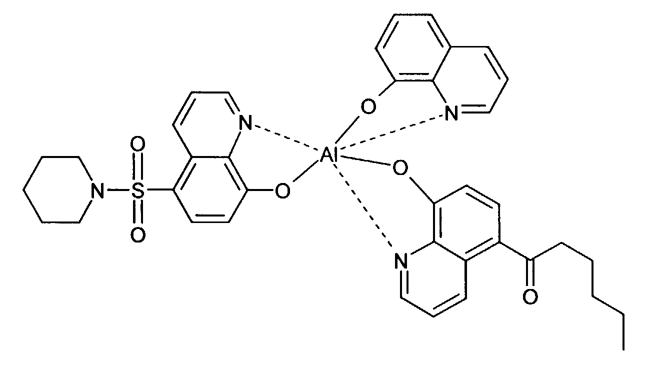

### Beispiel 22

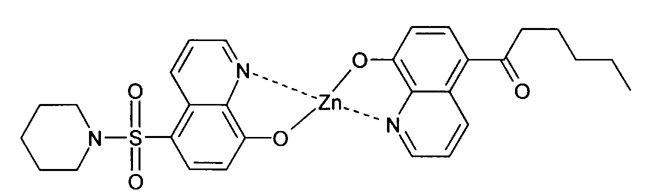

### Beispiel 23

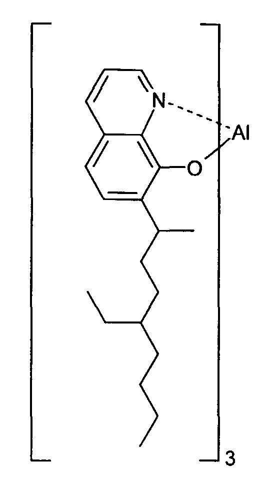

### Beispiel 24

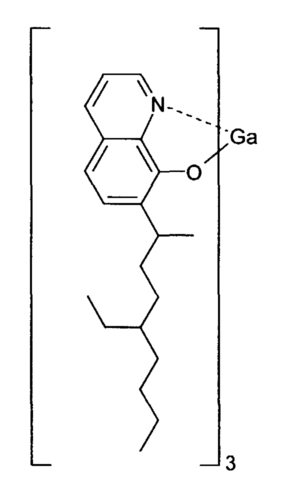

### Beispiel 25

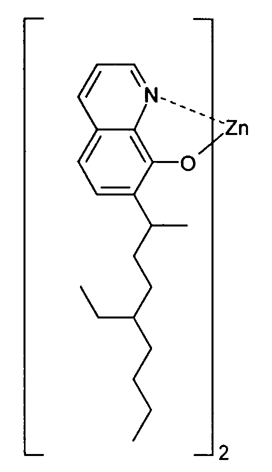

### Beispiel 26

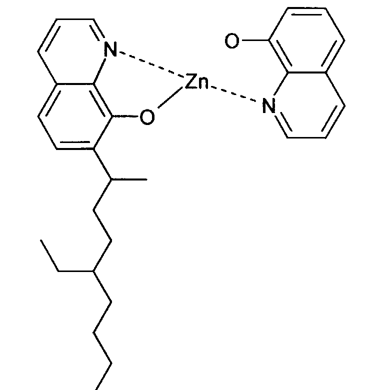

### Beispiel 27

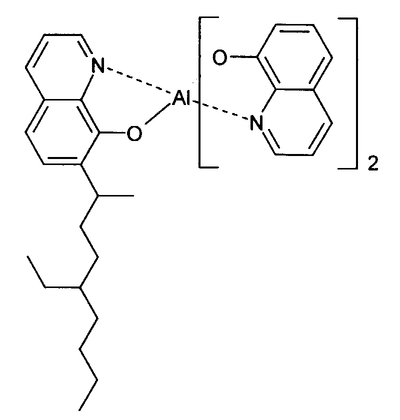

### Beispiel 28

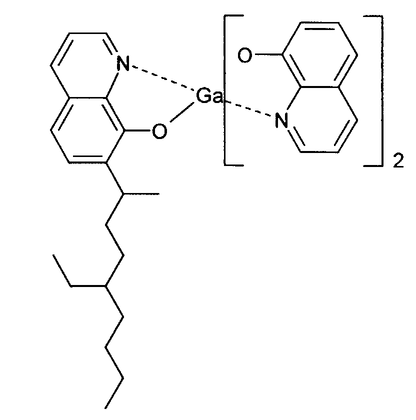

### Beispiel 29

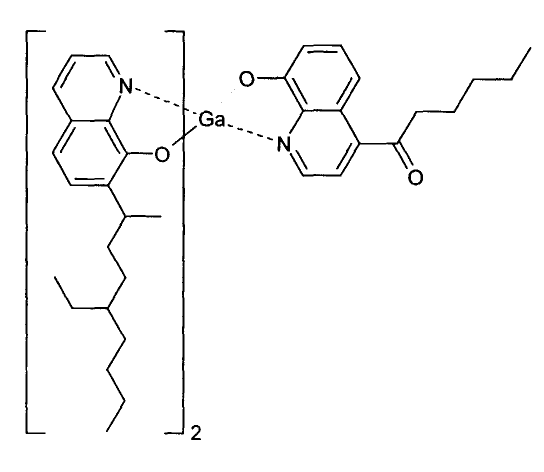

### Beispiel 30

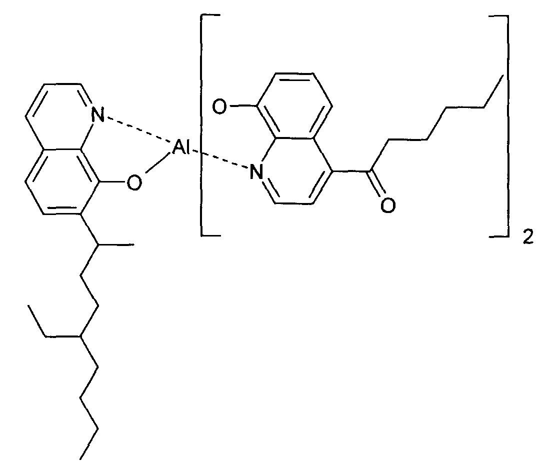

### Beispiel 31

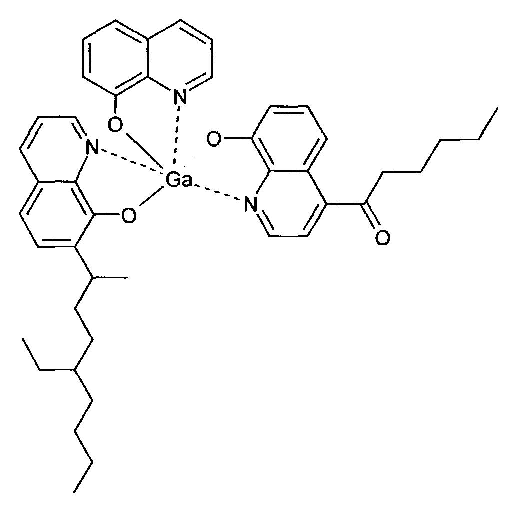

### Beispiel 32

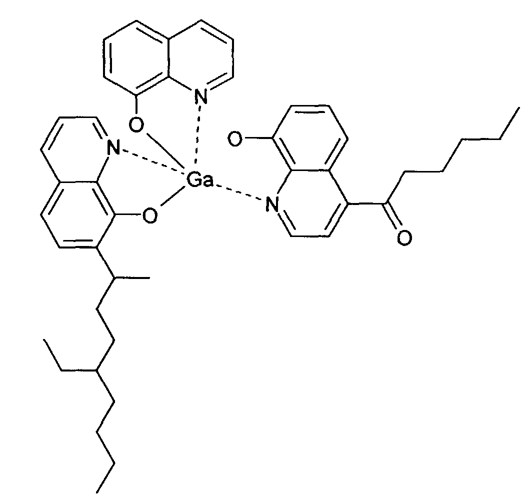

Die erfindungsgemäßen elektrolumineszierenden Anordnungen sind dadurch gekennzeichnet, daß sie eine lichtemittierende Schicht aufweisen, die eine Mischung der Komponenten A) und B) in gegebenenfalls einem transparenten Binder C) enthält. Dabei ist das Gewichtsverhältnis von A) und B) untereinander variabel einstellbar.

Der Gewichtsanteil der Summe der Gewichtsanteile von A) und B) im polymeren Binder liegt im Bereich von 0,2 bis 98 Gew.-%, bevorzugt von 2 bis 95 Gew.-%, besonders bevorzugt von 10 bis 90 Gew.-%, ganz besonders bevorzugt 10 bis 85 Gew.-%.

Das Gewichtsverhältnis A:B der Bestandteile A und B liegt zwischen 0,05 und 20, bevorzugt 0,2 und 10 und besonders bevorzugt zwischen 0,3 und 8, insbesondere 0,3 bis 7. Die Komponenten A) und B) können entweder aus einem Bestandteil oder einem Gemisch von Bestandteilen beliebiger Zusammensetzung bestehen.

Zur Herstellung der Schicht werden die Komponenten A), B) und gegebenenfalls C) in einem geeigneten Lösemittel gelöst und durch Gießen, Rakeln oder spincoating auf eine geeignete Unterlage aufgebracht. Dabei kann es sich z.B. um Glas oder ein Kunststoffmaterial handeln, das mit einer transparenten Elektrode versehen ist. Als Kunststoffmaterial kann z.B. eine Folie aus Polycarbonat, Polyester wie Polyethylenterephthalat oder Polyethylennaphthalat, Polysulfon oder Polyimid eingesetzt werden.

Zur Herstellung der Schicht kann die Komponente B) auch separat aus Lösung auf eine bereits bestehende Schicht aus den Komponenten A) und C) aufgebracht werden.

Als transparente Elektroden sind geeignet
a) Metallooxide, z.B. Indium-Zinn-Oxid (ITO), Zinnoxid (NESA), Zinkoxid, dotiertes Zinnoxid, dotiertes Zinkoxid, etc.,
b) semi-transparente Metallfime, z.B. Au, Pt, Ag, Cu etc.,
c) leitfähige Polymerfilme wie Polyaniline, Polythiophene, etc.

Die Metalloxid- und die semitransparenten Metallfilmelektroden werden durch Techniken wie Aufdampfen, Aufsputtern, Platinierung, etc., in dünner Schicht aufgebracht. Die leitfähigen Polymerfilme werden durch Techniken wie Spincoaten, Casting, Rakeln etc. aus der Lösung aufgebracht.

Die Dicke der transparenten Elektrode beträgt 3 nm bis etwa mehrere µm, vorzugsweise 10 nm bis 500 nm.

Die elektrolumineszierende Schicht wird direkt auf die transparente Elektrode oder auf eine gegebenenfalls vorhandene ladungstransportierende Schicht als dünner Film aufgebracht. Die Dicke des Films beträgt 10 bis 500 nm, vorzugsweise 20 bis 400 nm, besonders bevorzugt 50 bis 250 nm.

Auf die elektrolumineszierende Schicht kann eine weitere ladungstransportierende Schicht eingefügt werden, bevor eine Gegenelektrode aufgebracht wird.

Eine Zusammenstellung von geeigneten ladungstransportierenden Zwischenschichten, bei denen es sich um loch- und/oder elektronenleitenden Materialien handeln kann, die in polymerer oder niedermolekularer Form gegebenenfalls als Blend vorliegen können, ist in EP-A 532 798 aufgeführt. Besonders geeignet sind speziell substituierte Polythiophene, die über lochtransporierende Eigenschaften verfügen. Sie sind beispielsweise in EP-A 686 662 beschrieben.

Der Gehalt an niedermolekularem Lochleiter in einem polymeren Binder ist im Bereich von 2 bis 97 Gew.-% variierbar; bevorzugt beträgt der Gehalt 5 bis 95 Gew.-%, besonders bevorzugt 10 bis 90 Gew.-%, insbesondere 10 bis 85 Gew.-%. Die lochinjizierenden bzw. lochleitenden Zonen können mit verschiedenen Methoden deponiert werden.

Filmbildende Lochleiter können auch in reiner Form (100 %ig) eingesetzt werden. Gegebenenfalls kann auch die lochinjizierende bzw. lochleitende Zone Anteile einer elektrolumineszierenden Substanz enthalten.

Filmbildende Emitter/Elektronenleiter können ebenfalls in reiner Form (100 %ig) eingesetzt werden.

Blends, die ausschließlich aus niedermolekularen Verbindungen bestehen, können aufgedampft werden; lösliche und filmbildende Blends, die neben niedermolekularen Verbindungen auch einen Binder C) enthalten können (nicht notwendigerweise), können aus einer Lösung z.B. mittels Spin-Loating, Gießen, Rakeln deponiert werden.
Es ist auch möglich, emittierende und/oder elektronenleitende Substanzen in einer separaten Schicht auf die lochleitende Schicht mit der Komponente A aufzubringen. Dabei kann eine emittierende Substanz auch der die Verbindung A und/oder B enthaltenden Schicht zudotiert ("Dopant") und zusätzlich eine elektronenleitende Substanz aufgebracht werden. Eine elektrolumineszierende Substanz kann auch der elektroneninjizierenden bzw. elektronenleitenden Schicht zugesetzt werden.

Der Gehalt an niedermolekularen Elektronenleitern im polymeren Binder ist im Bereich von 2 bis 95 Gew.-% variierbar; bevorzugt beträgt der Gehalt 5 bis 90 Gew.-%, besonders bevorzugt 10 bis 85 Gew.-%. Filmbildende Elektronenleiter können auch in reiner Form (100 %ig) eingesetzt werden.

Die Gegenelektrode besteht aus einer leitfähigen Substanz, die transparent sein kann. Vorzugsweise eignen sich Metalle, z.B. Al, Au, Ag, Mg, In, etc. oder Legierungen und Oxide dieser, die durch Techniken wie Aufdampfen, Aufsputtern, Platinierung aufgebracht werden können.

Die erfindungsgemäße Anordnung wird durch zwei elektrische Zuführungen (z.B. Metalldrähte) mit den beiden Elektroden in Kontakt gebracht.

Die Anordnungen emittieren beim Anlegen einer Gleichspannung im Bereich von 0,1 bis 100 Volt Licht der Wellenlänge von 200 bis 2000 nm. Sie zeigen im Bereich von 200 bis 2000 nm Photolumineszenz.

Die erfindungsgemäßen Anordnungen sind zur Herstellung von Einheiten zur Beleuchtung und zur Informationsdarstellung geeignet.

### Beispiele

### A) Synthese

### Beispiel 1

### Ligandensynthese am Beispiel des 5(7)-Hexanoyl-8-hydroxychinolins (Friedel-Crafts-Acylierung)

0,5 mol (66,7 g) Aluminiumchlorid werden in 150 ml Nitrobenzol gelöst und unter Rühren zu 0,2 mol (29,0 g) 8-Hydroxychinolin, gelöst in 50 ml Nitrobenzol, gegeben. Dazu tropft man 0,2 mol (26,9 g) Hexanoylchlorid und rührt 10 Stunden bei 80°C. Nach dem Abkühlen wird das Reaktionsgemisch auf 500 g Eis und 20 ml konzentrierte Salzsäure gegossen. In der Wärme wird die organische Schicht abgetrennt. Das Nitrobenzol wird mit Wasserdampf entfernt, der Rückstand isoliert und mit gesättigter Natriumacetat-Lösung behandelt. Anschließend wird mit Diethylether extrahiert, das Lösungsmittel abdestilliert.
Ausbeuten:
   5-Hexanoyl-8-hydroxychinolin 9,2 g (19 %)
   7-Hexanoyl-8-hydroxychinolin 13,6 g (28 %)

Diese Verbindungen werden chromatographisch getrennt.

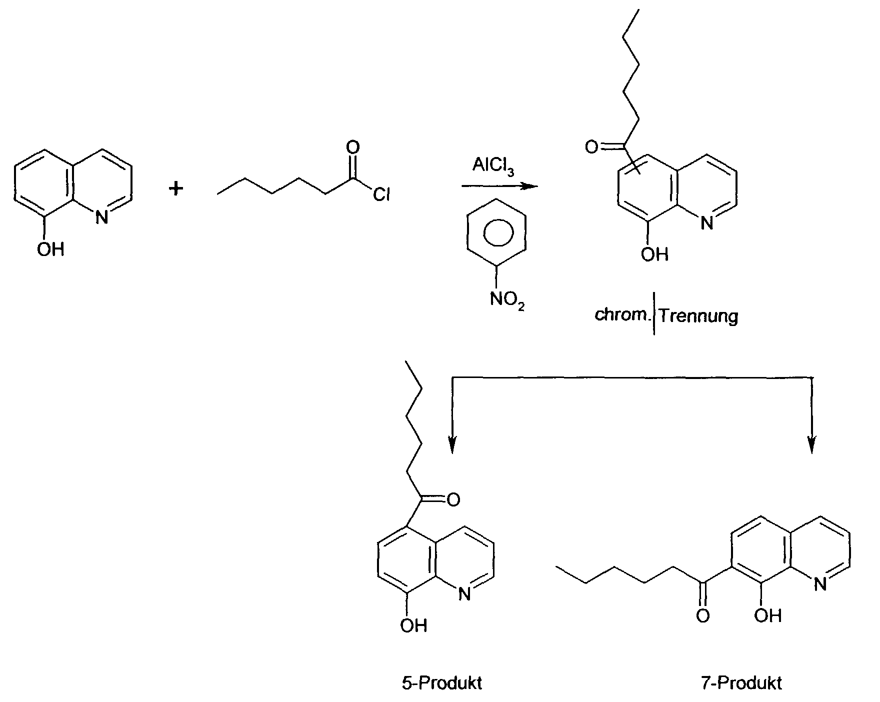

### Beispiel 2

### Darstellung der Metallkomplexe am Beispiel von Tri-(5-hexanoyl-8-hydroxychinolin)-aluminium

10 mmol (2,4 g) Aluminiumchlorid-hexahydrat werden in 50 ml Wasser gelöst. Dazu tropft man eine Lösung von 30 mmol 5-Hexanoyl-8-hydroxychinolin (7,3 g) in 50 ml Ethanol. Man erwärmt auf 60°C und stellt den pH-Wert mit 2 M Kaliumcarbonat-Lösung auf 8 bis 9 ein. Danach wird 1 Stunde bei 70°C gerührt. Nach dem Abkühlen wird der Niederschlag isoliert und mit der Mutterlauge und heißem Wasser gewaschen sowie anschließend im Hochvakuum getrocknet. Man erhält eine grün-gelbliche Substanz, die Fluoreszenz zeigt. Die NMR-Spektroskopie und die Elementaranalyse belegen, daß es sich um die gewünschte Verbindung handelt.
Ausbeute: 5,8 g (77 %)

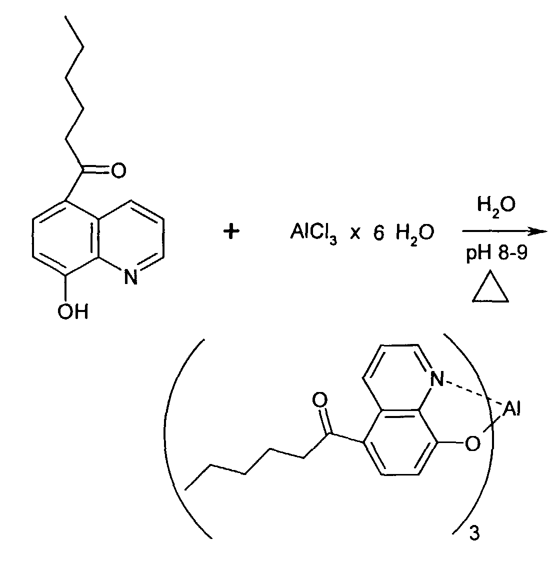

### Beispiel 3

### Herstellung eines Gallium-Komplexes

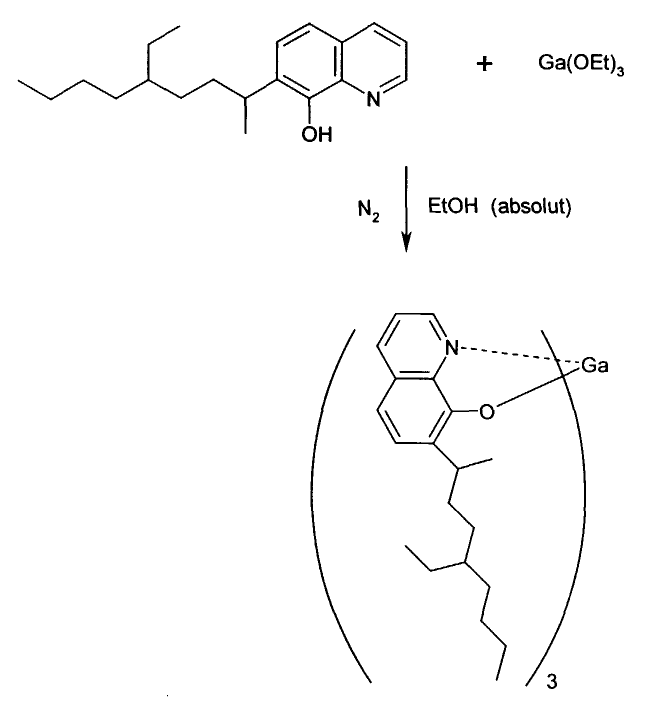

6,28 g (0,021 mol) 7-(4-Ethyl-1-methyloctyl)-8-hydroxychinolin wird zusammen mit 1,4 g (0,007 mol) Gallium(III)-ethoxid in 50 ml absolutem Ethanol vorgelegt. Unter Rühren erhitzt man den Reaktionsansatz am Rückfluß solange, bis unter DC-Kontrolle möglichst vollständiger Umsatz stattgefunden hat. Das Lösungsmittel wird abgetrennt und man erhält 6,5 g (0,0067 mol, 96 % der Theorie) an intensiv fluoreszierender Ga-Komplexverbindung die in Methanol vollständig löslich ist.

### Beispiel 4

### Herstellung eines Gallium-Komplexes

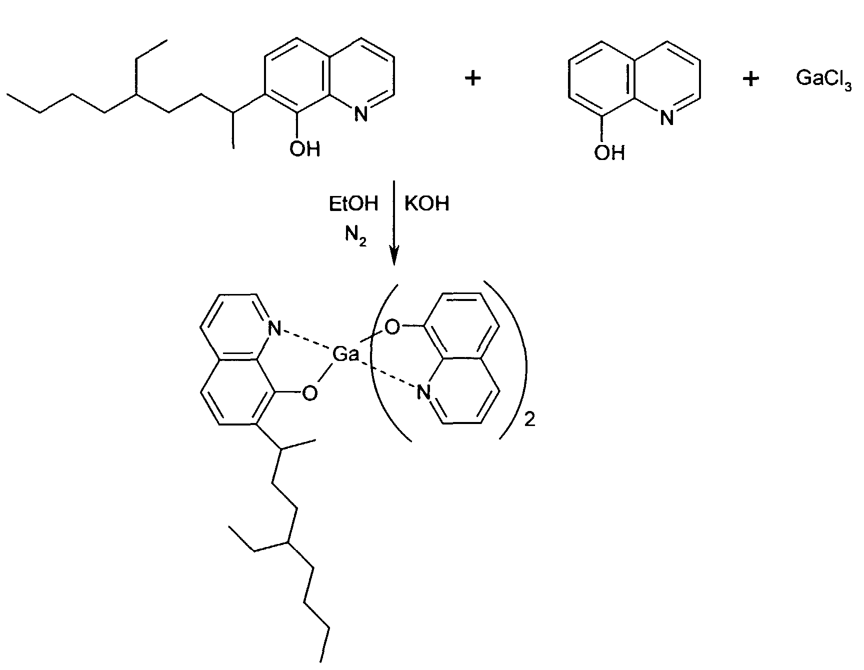

1 g (0,003 mol) 7-(4-Ethyl-1-methyloctyl)-8-hydroxychinolin wird zusammen mit 0,93 g (0,006 mol) 8-Hydroxychinolin, 6,28 g einer 9 %igen GaCl₃-Lösung in Methanol und 0,54 g (0,009 mol) Kaliumhydroxid in 50 ml absolutem Ethanol vorgelegt. Der Reaktionsansatz wird 6 Stunden am Rückfluß gekocht. Nach Abtrennen des Lösungsmittels erhält man 1,44 g (0,002 mol, 73 % derTheorie) der intensiv fluoreszierenden Ga-Komplexverbindung, die in Methanol vollständig löslich ist.

Eine elektrolumineszierende Anordnung auf Basis eines Blendsystems aus den Komponenten A, B und C kann aus Lösung heraus mit einem Spincoater auf eine mit ITO beschichtete Glasplatte aufgebaut werden (vgl. z.B. EP-A 532 798).

Als Gegenelektrode wird Mg/Ag im Verhältnis 10:1 durch thermische Codeposition aufgebracht.

Nach Kontaktierung und Anlegen eines elektrischen Feldes zeigt die Anordnung visuell erkennbare Elektrolumineszenz.

## Patentansprüche

1. Elektrolumineszierende Anordnungen, enthaltend ein Substrat, eine Anode, ein elektrolumineszierendes Element und eine Kathode, wobei wenigstens eine der beiden Elektroden im sichtbaren Spektralbereich transparent ist und das elektrolumineszierende Element oder mehrere Zonen aus der Gruppe der lochinjizierenden Zone, lochtransportierenden Zone, elektrolumineszierenden Zone, elektronentransportierenden Zone und elektroneninjizierenden Zone in der genannten Reihenfolge enthält, wobei jede der vorhandenen Zonen auch Funktionen der anderen genannten Zonen übernehmen kann, dadurch gekennzeichnet, daß die lochinjizierende und lochtransportierende Zone eine gegebenenfalls substituierte Tris-1,3,5-(aminophenyl)benzolverbindung A enthält und das elektrolumineszierende Element ein lumineszierendes Material B, ausgewählt aus Verbindungen der allgemeinen Formeln

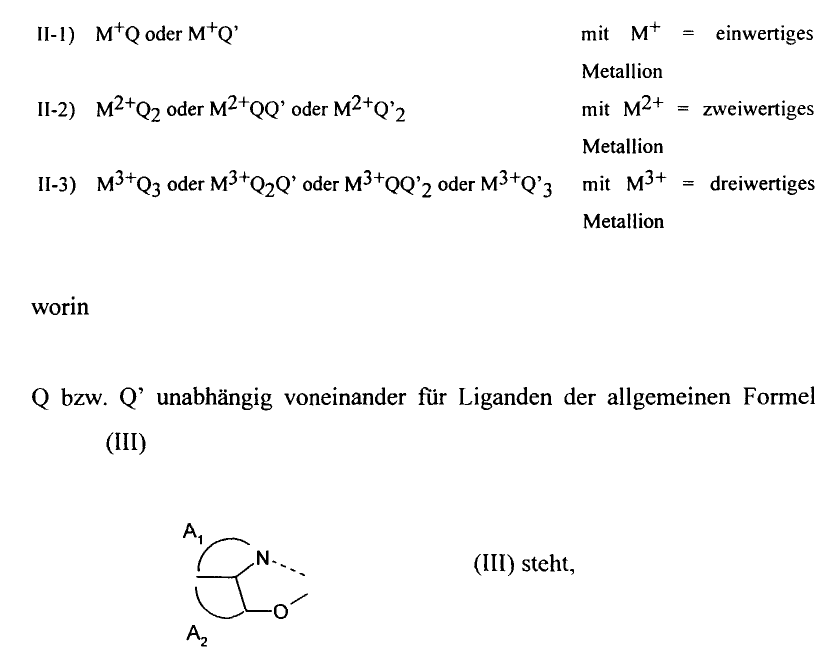

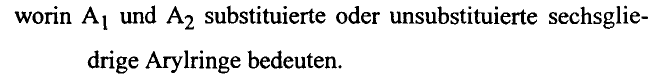

2. Elektrolumineszierende Anordnung gemäß Anspruch 1, dadurch gekennzeichnet, daß Komponente B) ausgewählt aus Verbindungen der allgemeinen Formel (II) ist 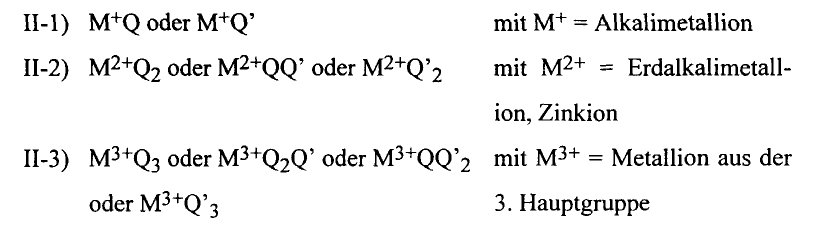
worin die ein-, zwei- oder dreiwertigen Metallionen zur Chelatbildung geeignet sind, und
Q und Q 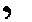 unabhängig voneinander für einen Rest der Formel (IV) 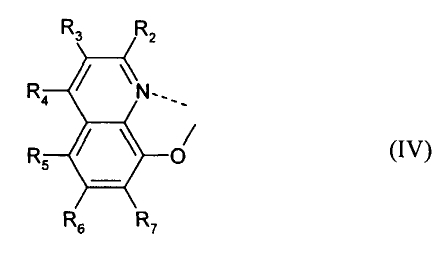 steht, wobei
R₃, R₄, R₆ = Wasserstoff ist,
R₂ = Wasserstoff oder jeweils gegebenenfalls substituiertes Alkyl, Aryl, Cycloalkyl, Heteroaryl ist,
R₅ oder R₇ = jeweils gegebenenfalls substituiertes Alkanoyl, Cycloalkanoyl, Aryloyl oder Heteroaryloxyl mit 6 bis 12 C-Atomen und Stickstoff, Sauerstoff und/oder Schwefel als Heteroatome bedeuten, und der jeweils andere Rest R₅ oder R₇ dann für Wasserstoff steht, oder
R₅ für Di(alkylamino) oder Di(cycloalkyl)amino oder Piperidylsulfamoyl steht und
R₇ Wasserstoff ist.

3. Elektrolumineszierende Anordnung gemäß Anspruch 1, dadurch gekennzeichnet, daß Komponente B) ausgewählt ist aus substituierten Oxin-Komplexen von Al³⁺, Ga³⁺, Mg²⁺, In³⁺, Li⁺, Ca²⁺, Zn²⁺, Na⁺ oder Seltenenerd-Metallkomplexen.

4. Elektrolumineszierende Anordnung gemäß Anspruch 1, dadurch gekennzeichnet, daß Komponente B) ausgewählt ist aus den folgenden Verbindungen:

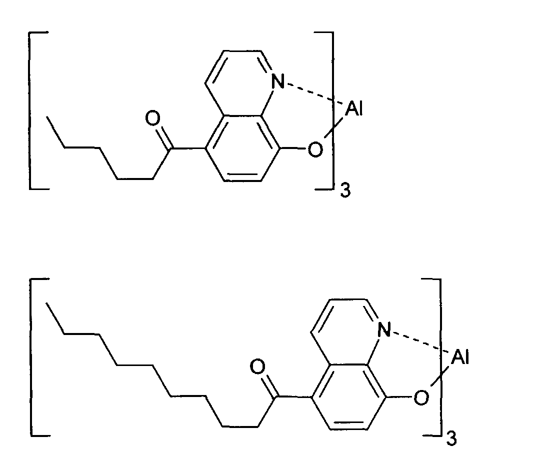

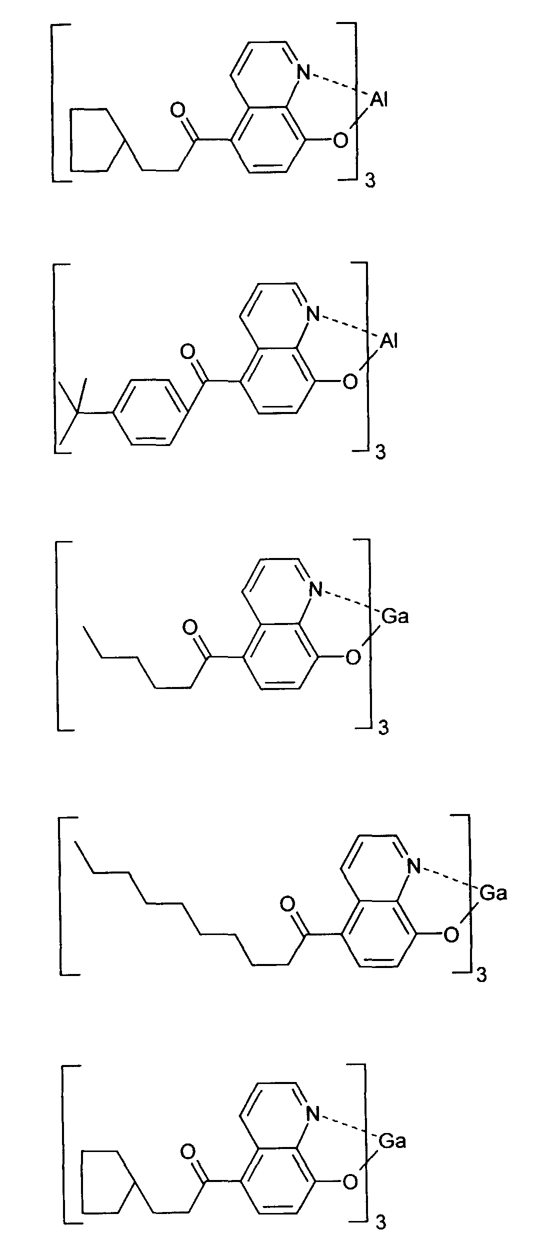

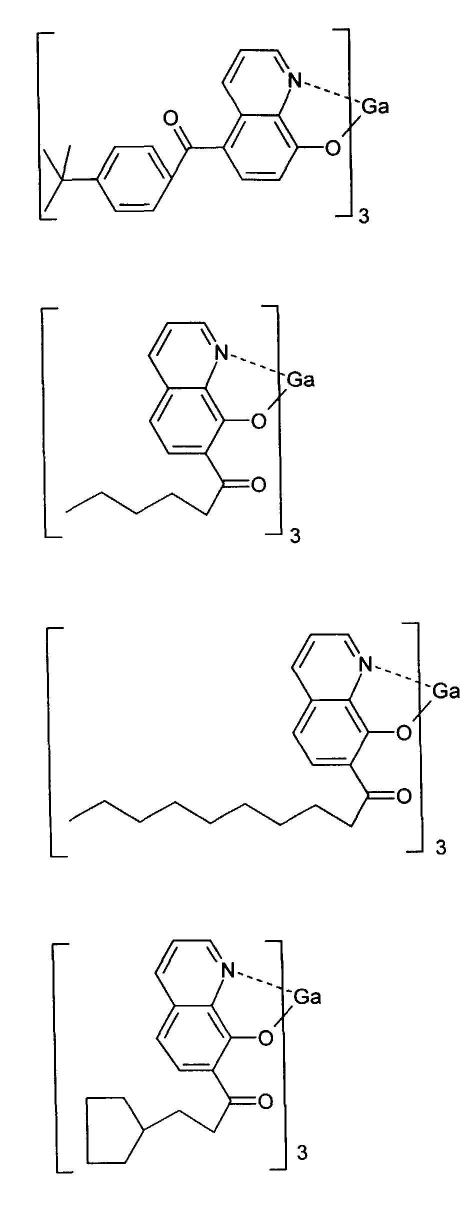

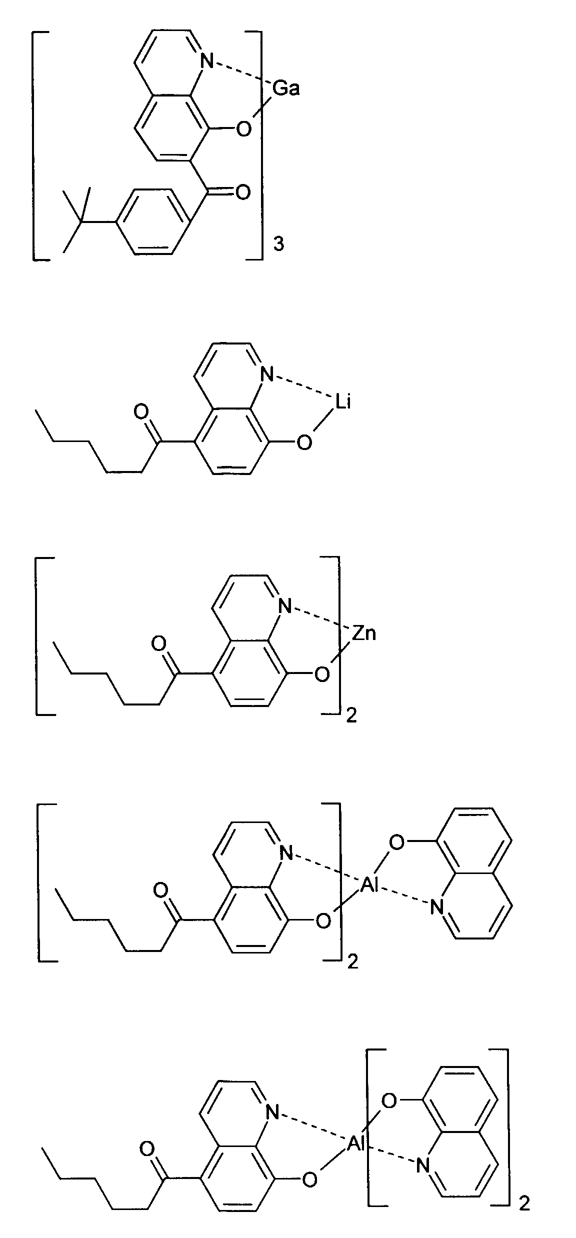

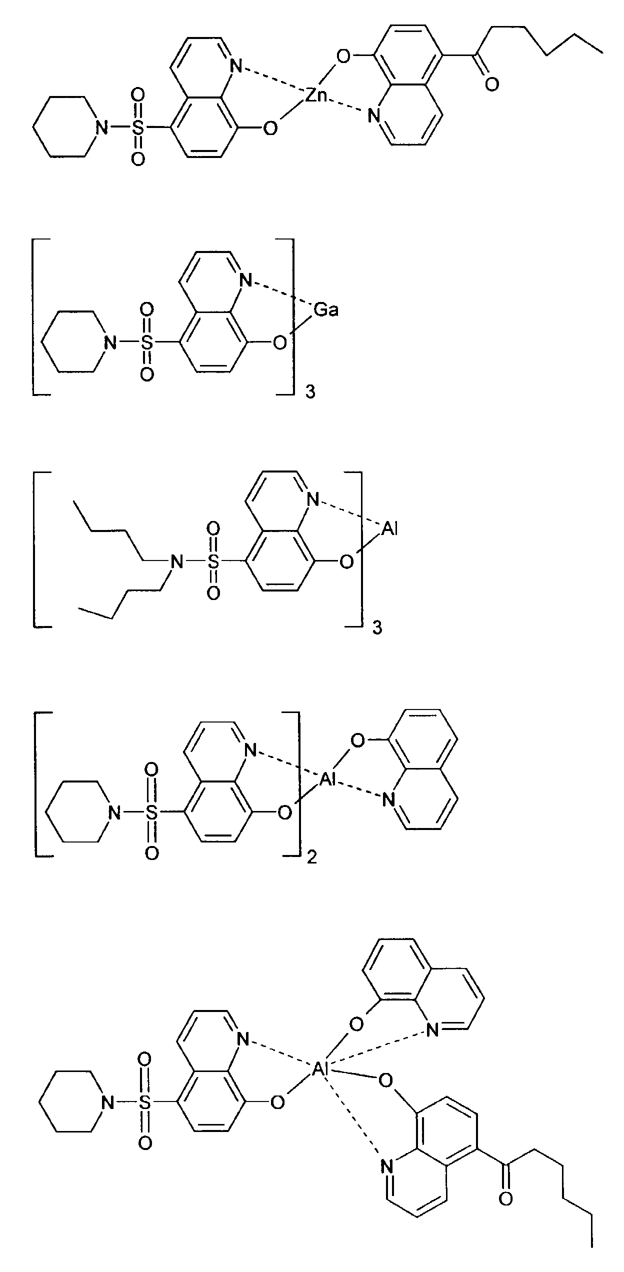

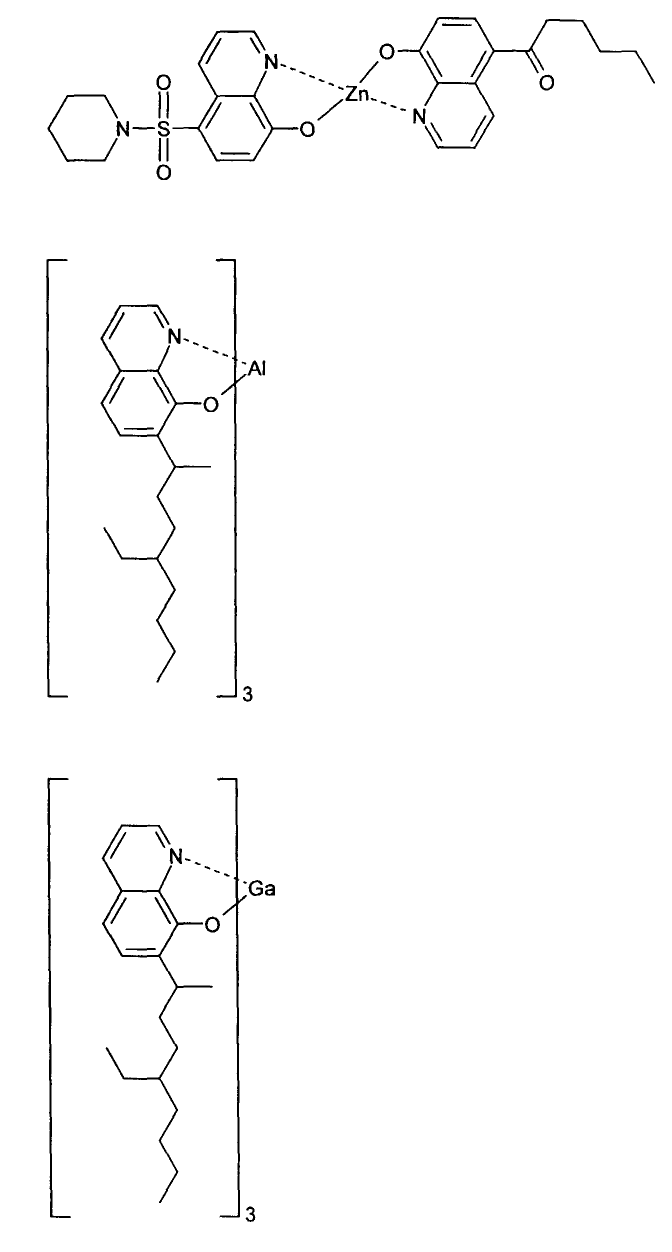

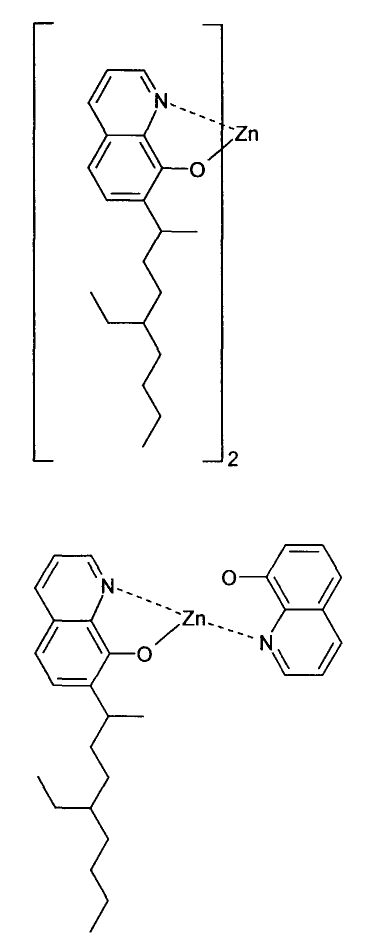

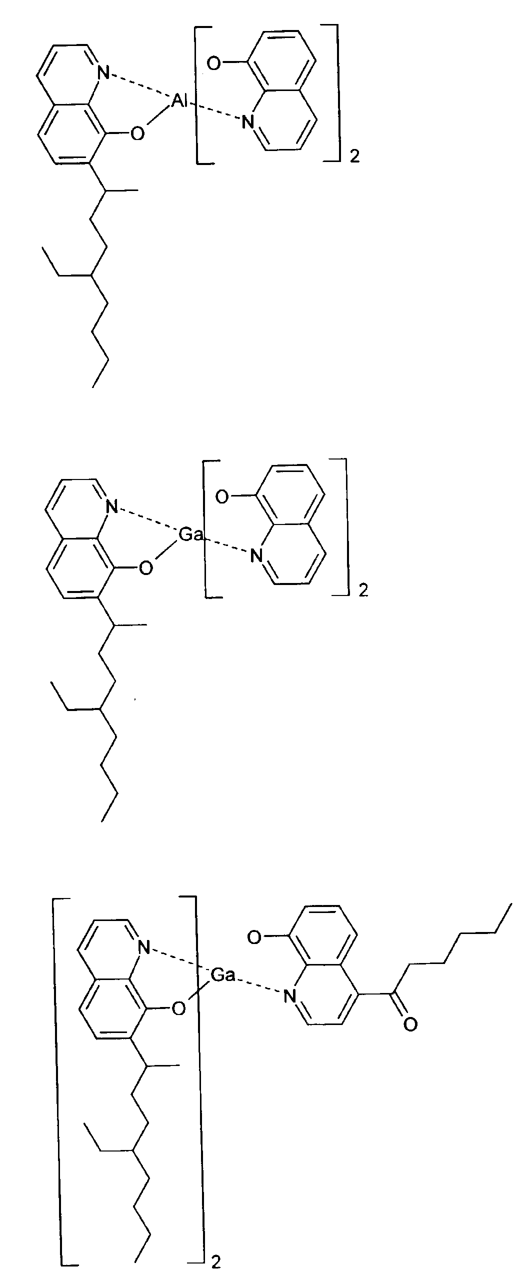

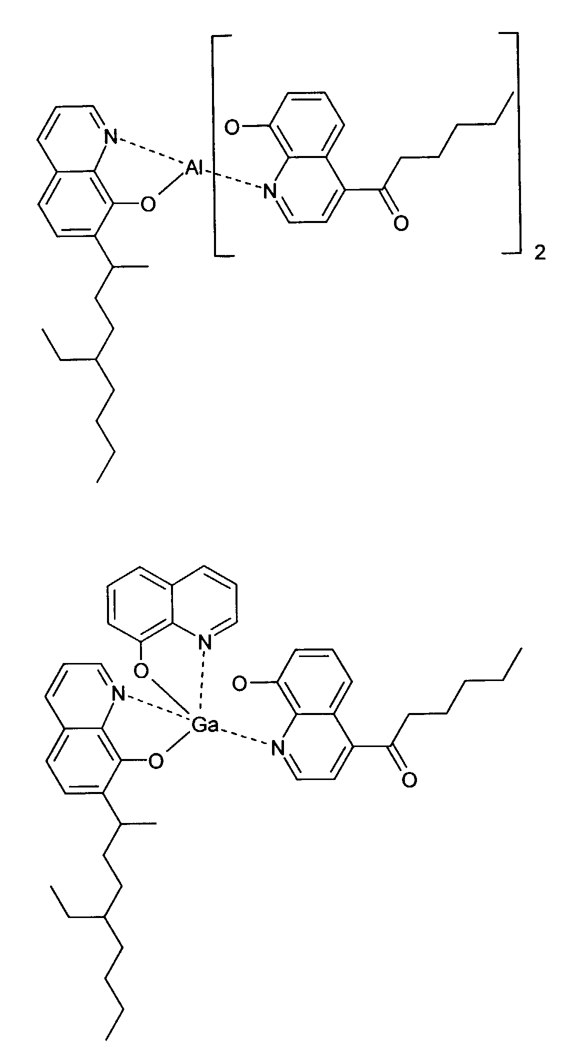

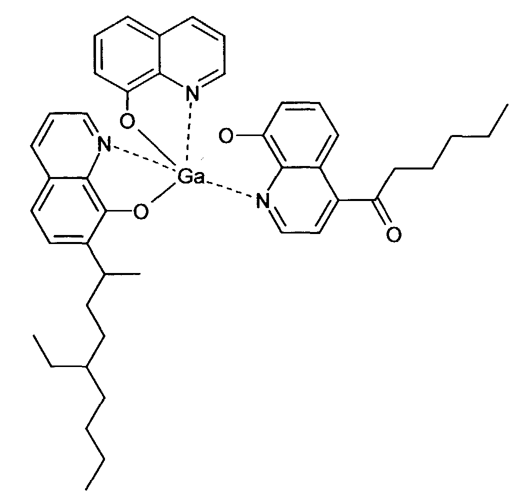

5. Elektrolumineszierende Anordnungen gemäß Anspruch 1, dadurch gekennzeichnet, daß das elektrolumineszierende Element einen transparenten polymeren Binder C) enthält.

6. Elektrolumineszierende Anrodnungen gemäß Anspruch 1, dadurch gekennzeichnet, daß die Verbindung A) eine aromatische tertiäre Aminoverbindung der allgemeinen Formel (I) ist 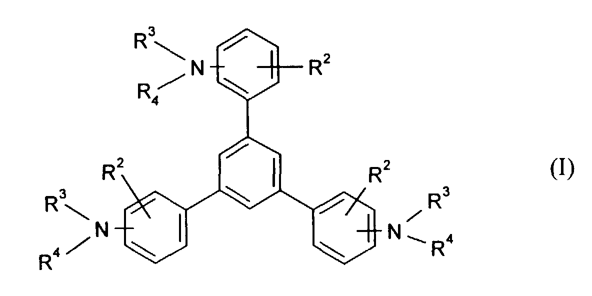 in welcher
R² für Wasserstoff, gegebenenfalls substituiertes Alkyl oder Halogen steht,
R³ und R⁴ unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen.

7. Elektrolumineszierende Anordnung gemäß Anspruch 6, dadurch gekennzeichnet, daß in Formel (I)
R² für Wasserstoff oder C₁-C₆-Alkyl steht,
R³ und R⁴ unabhängig voneinander für (C₁-C₆)-Alkyl, (C₁-C₄)-Alkoxycarbonyl-(C₁-C₆)-alkyl, jeweils gegebenenfalls durch (C₁-C₄)-Alkyl und/oder (C₁-C₄)-Alkoxy substituiertes Phenyl, Naphthyl, Phenyl(C₁-C₄)-alkyl, Naphthyl-(C₁-C₄)-alkyl, Cyclopentyl oder Cyclohexyl stehen.

8. Elektrolumineszierende Anordnung gemäß Anspruch 1, dadurch gekennzeichnet, daß das tertiäre Amin A) ausgewählt ist aus den folgenden Verbindungen:

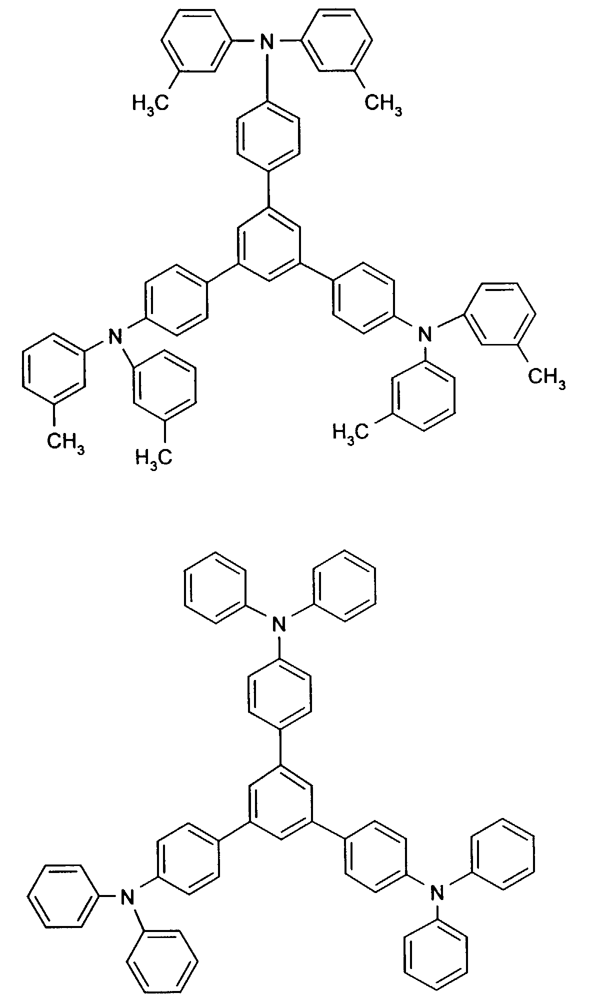

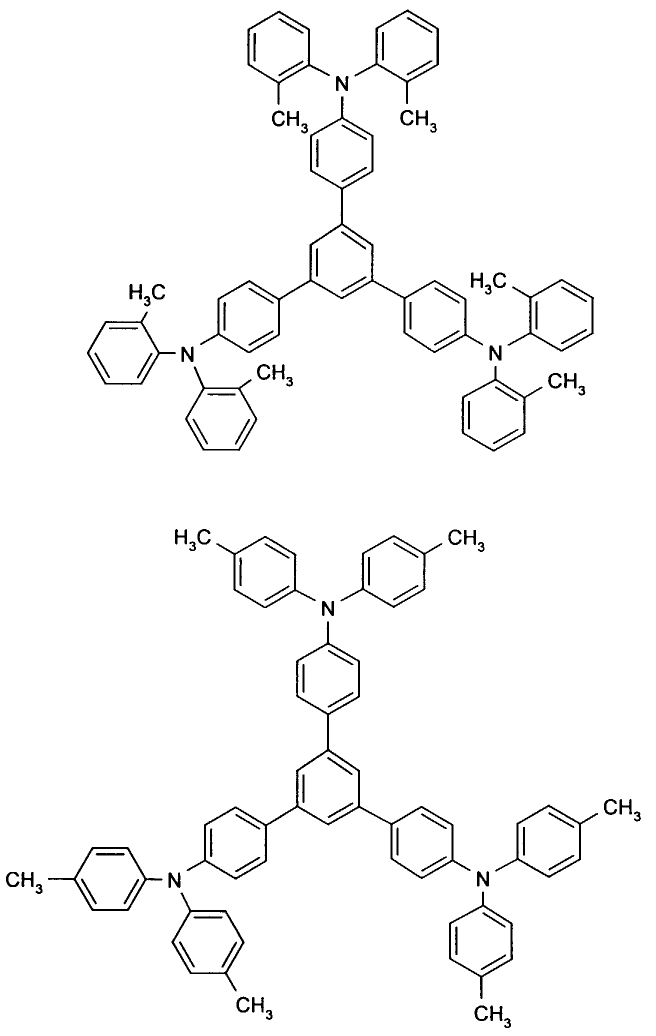

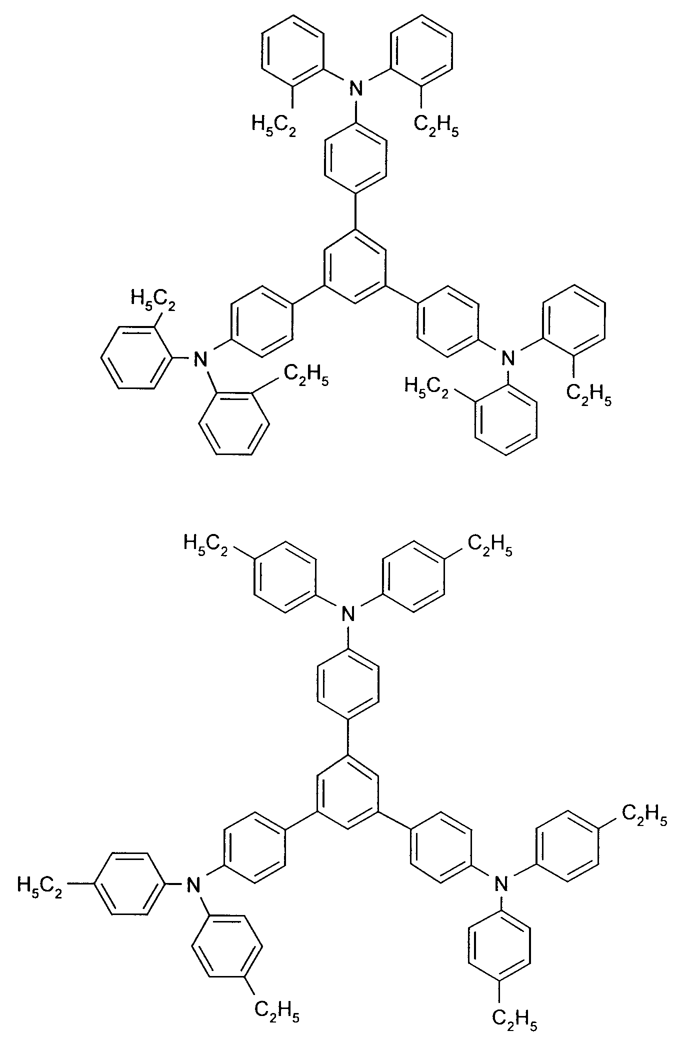

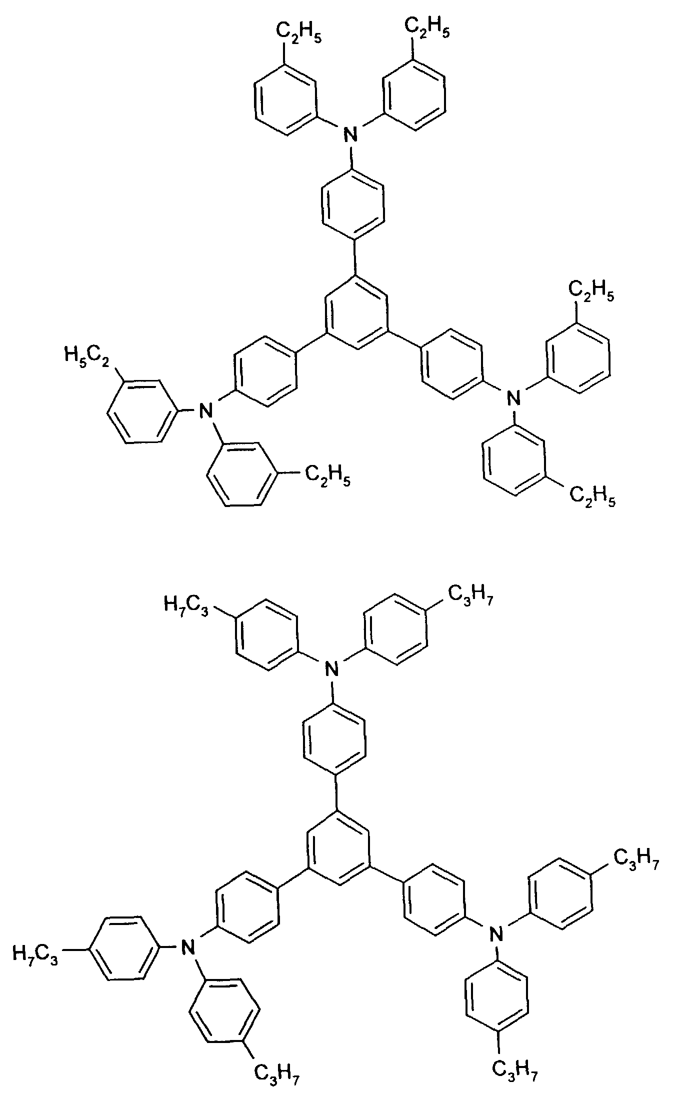

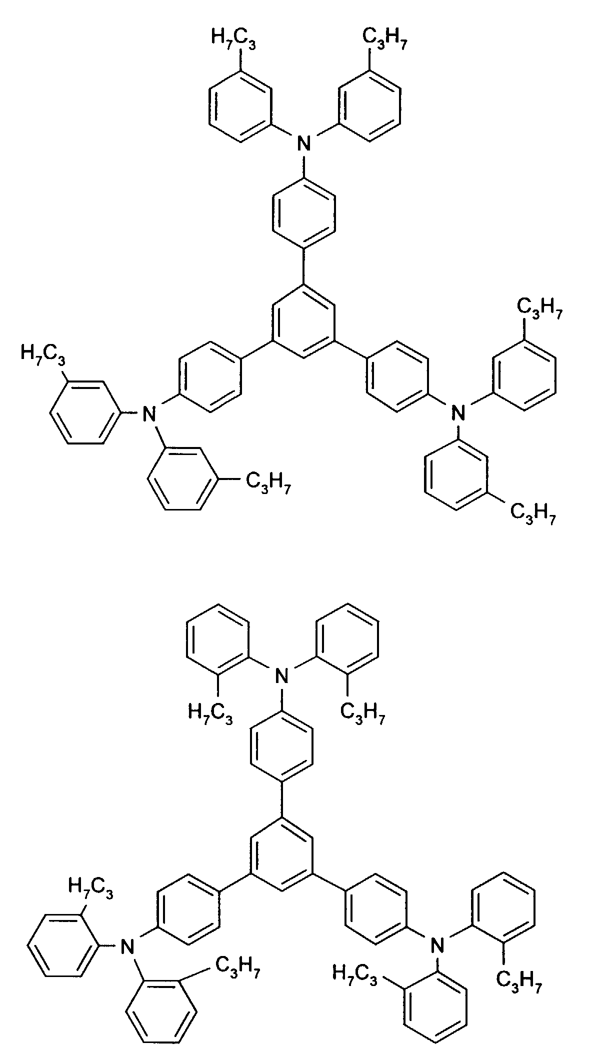

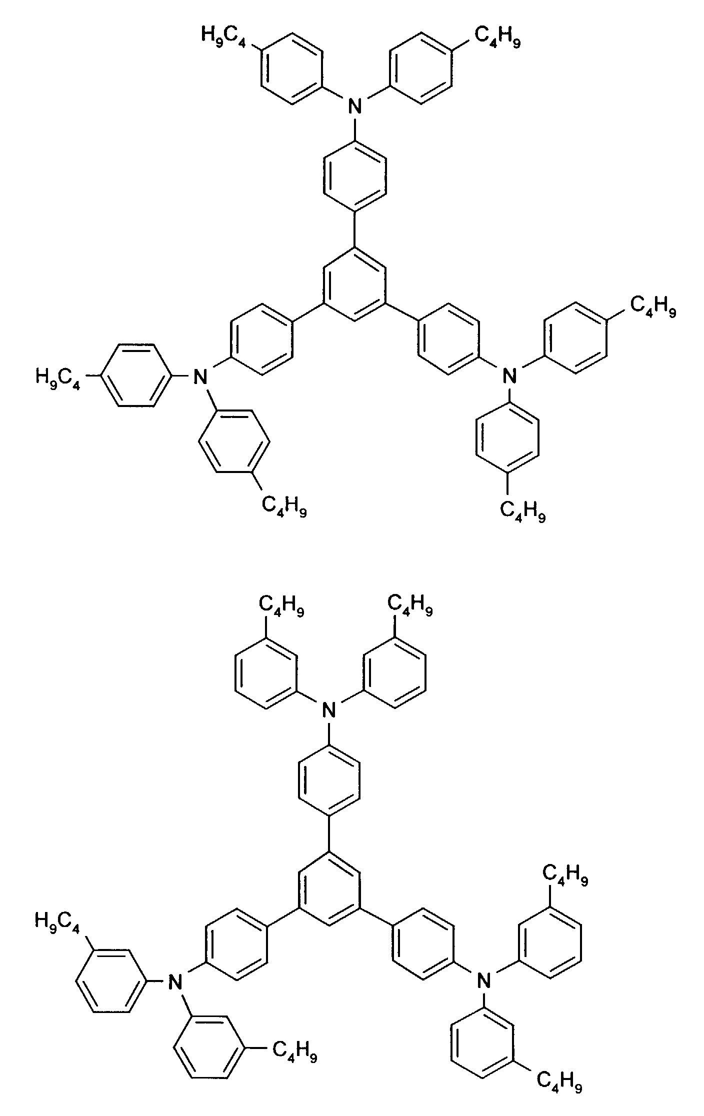

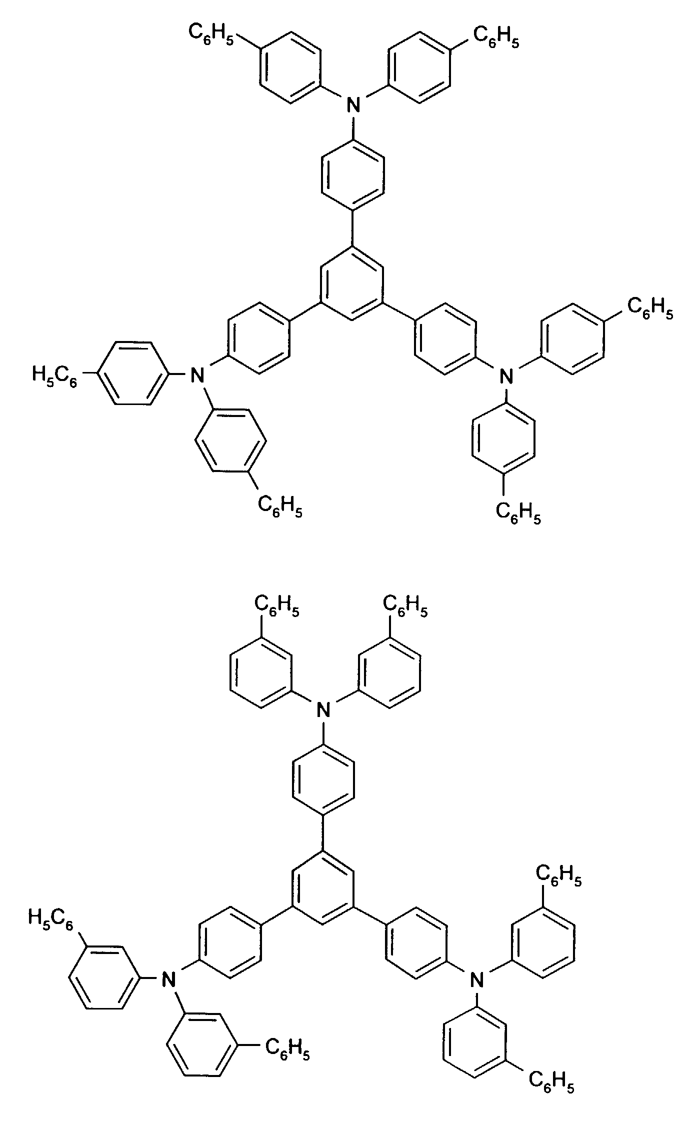

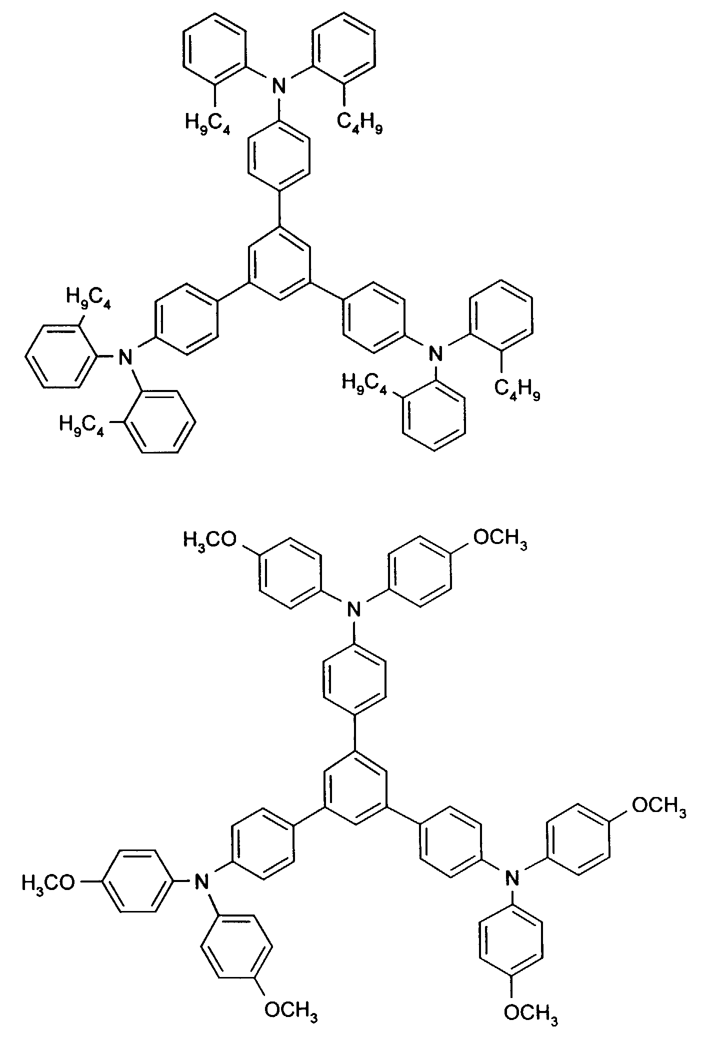

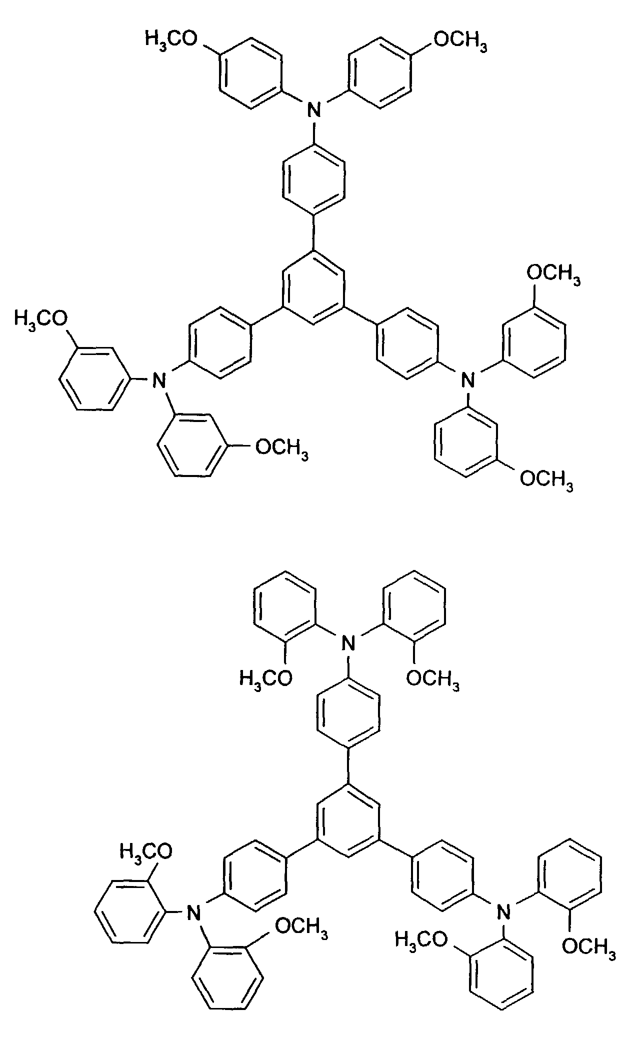

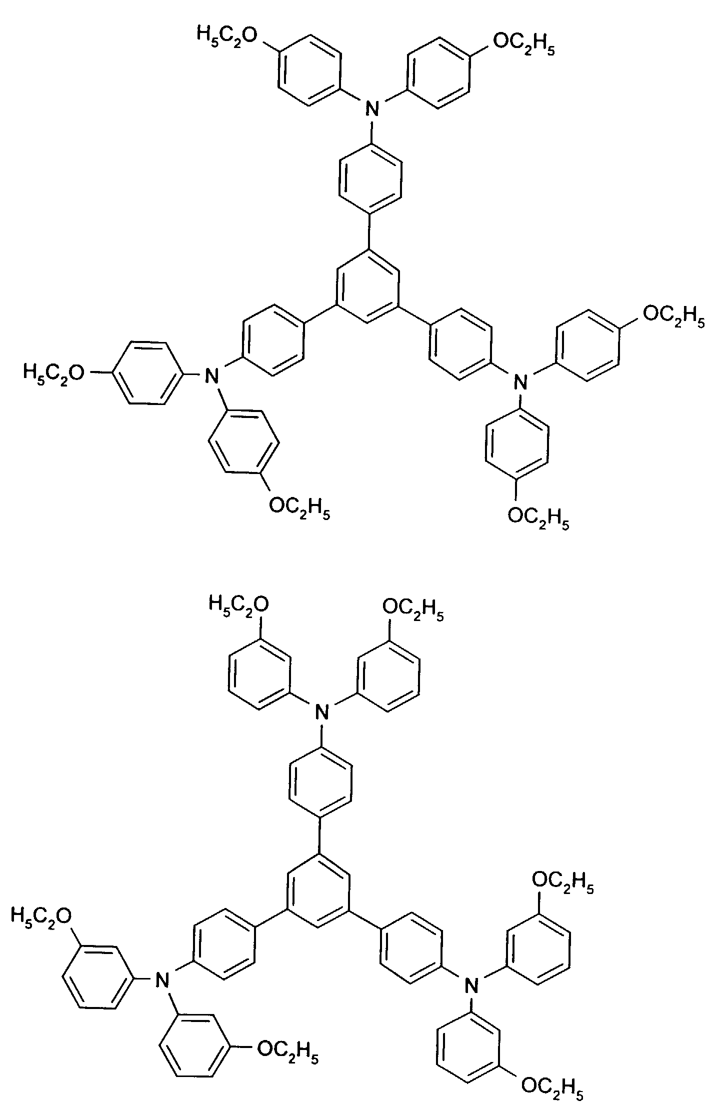

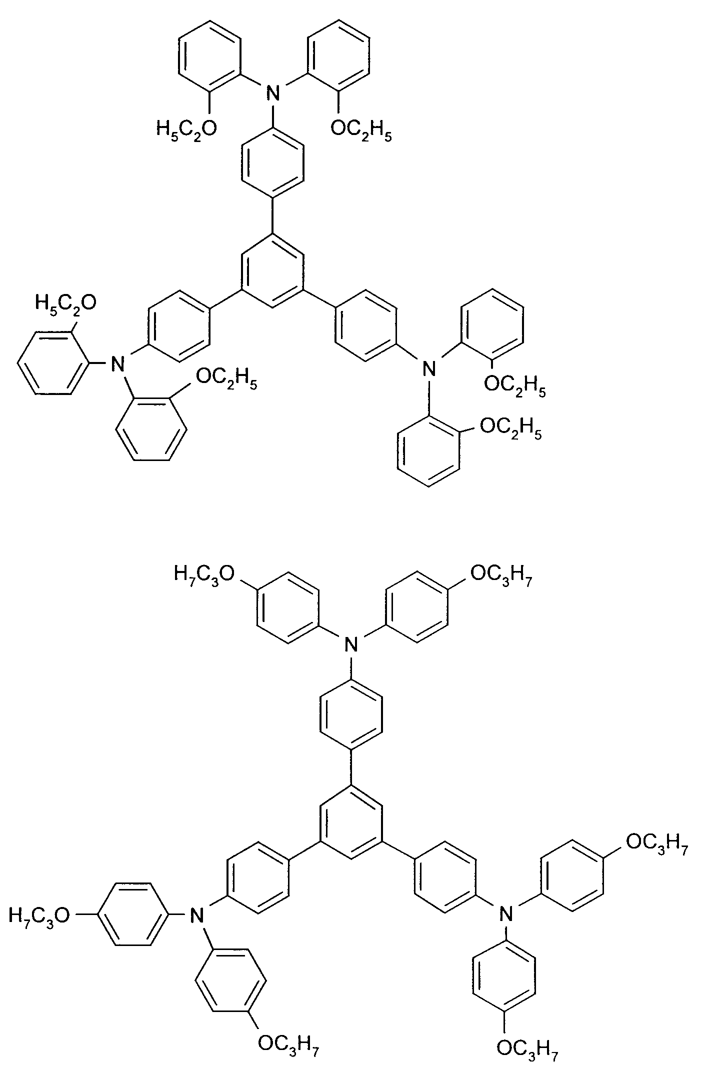

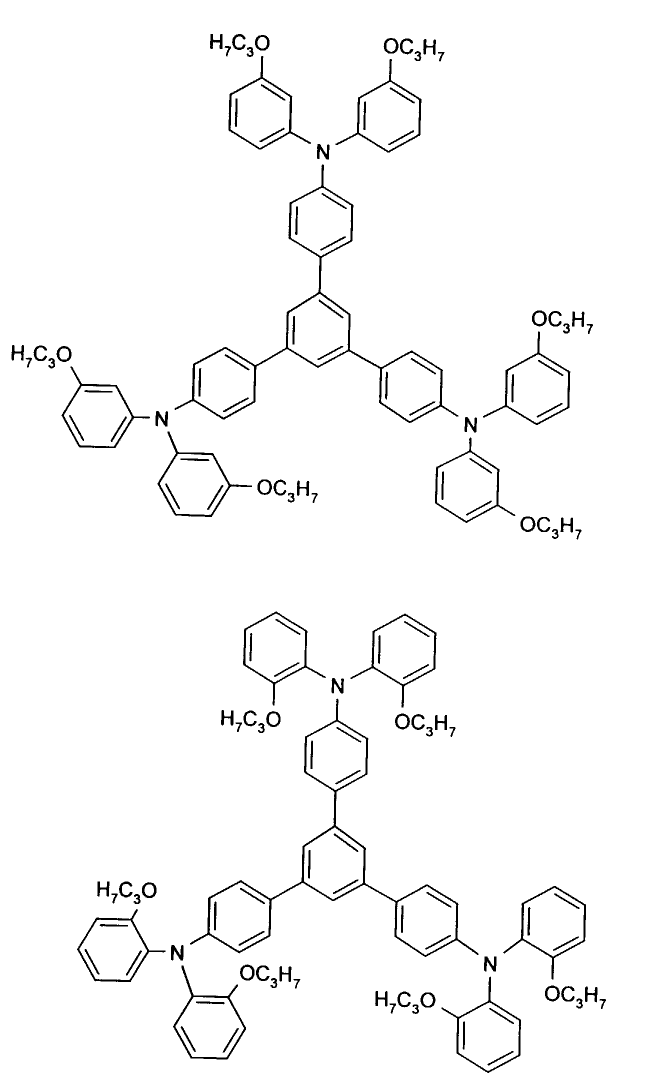

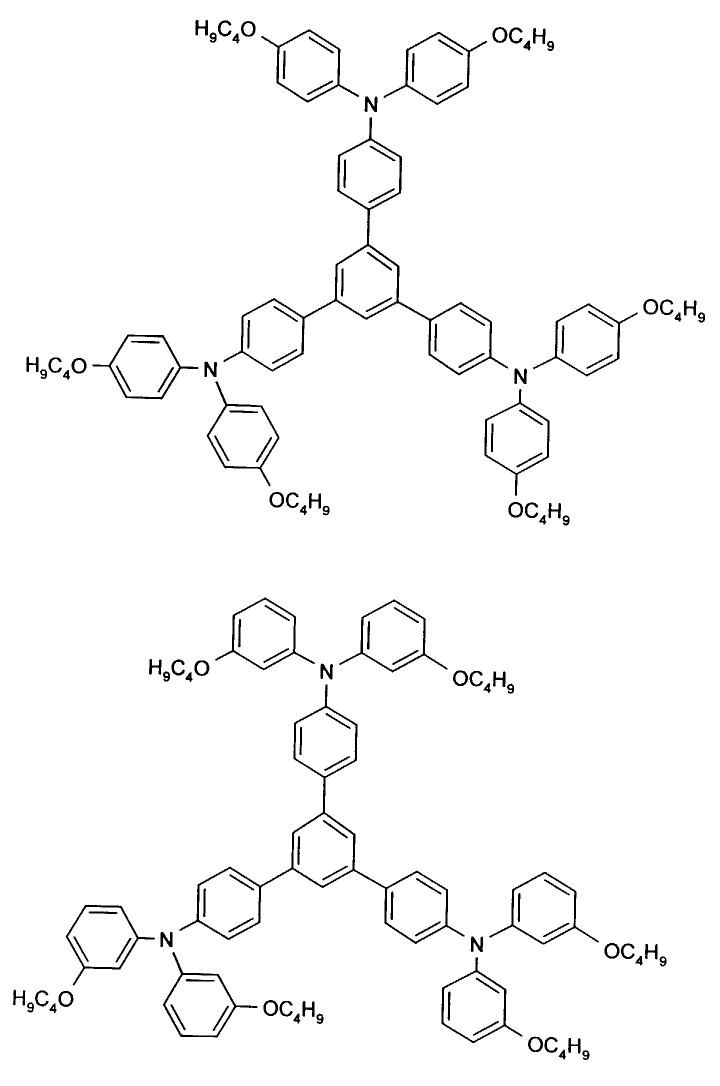

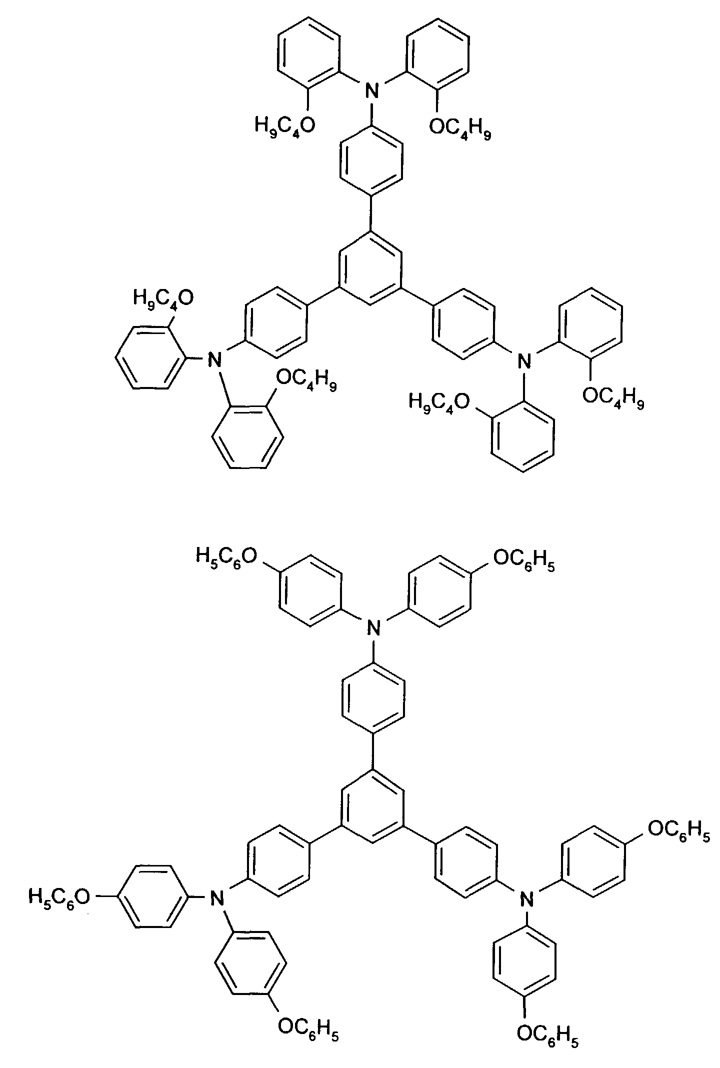

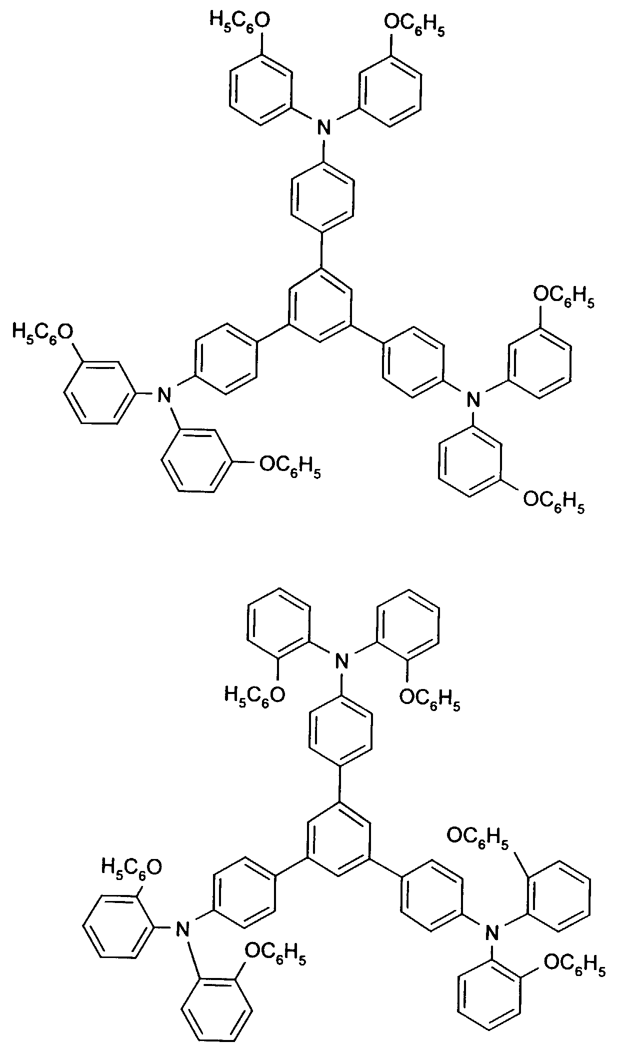

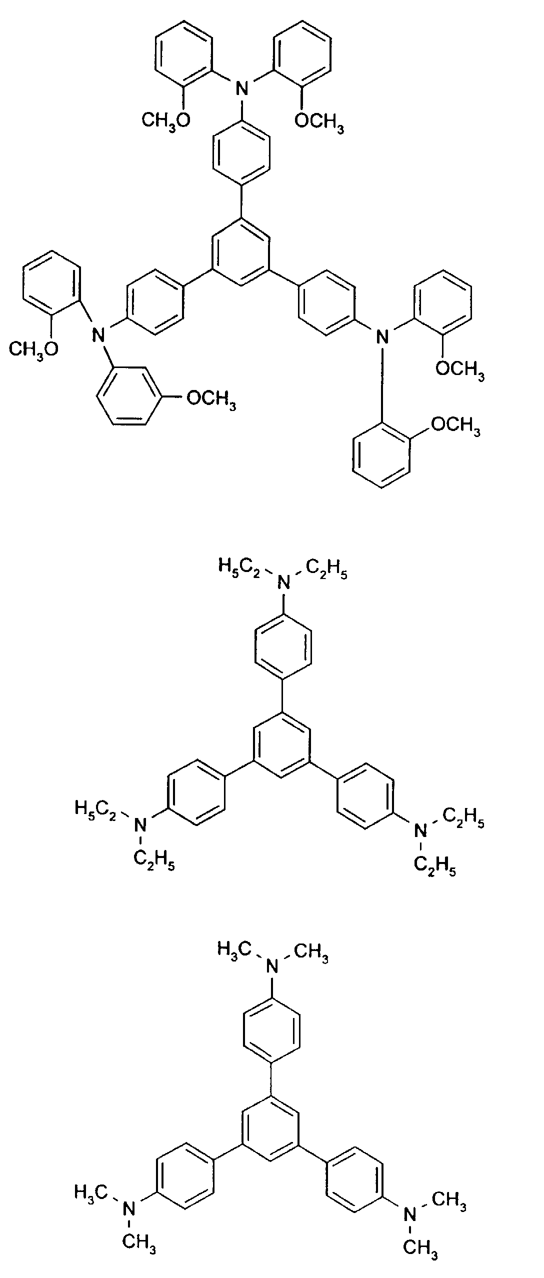

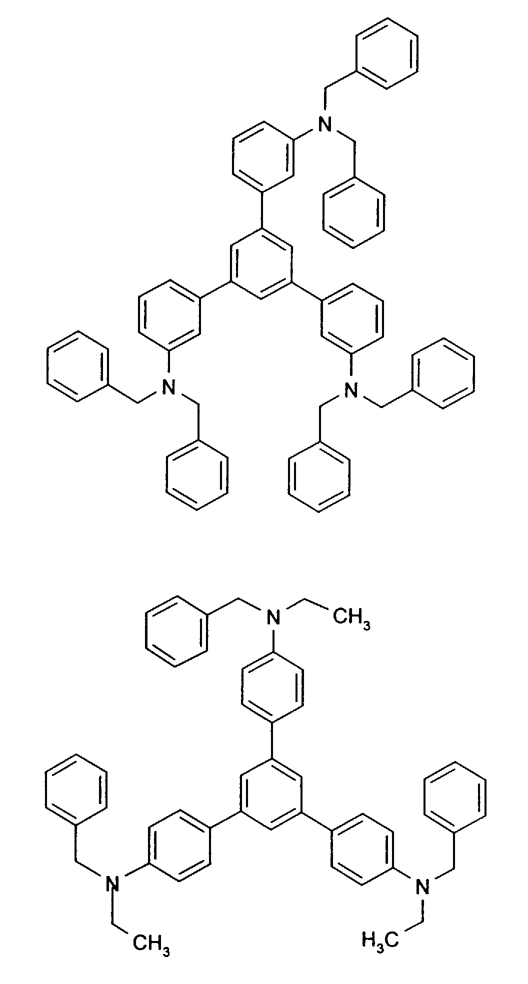

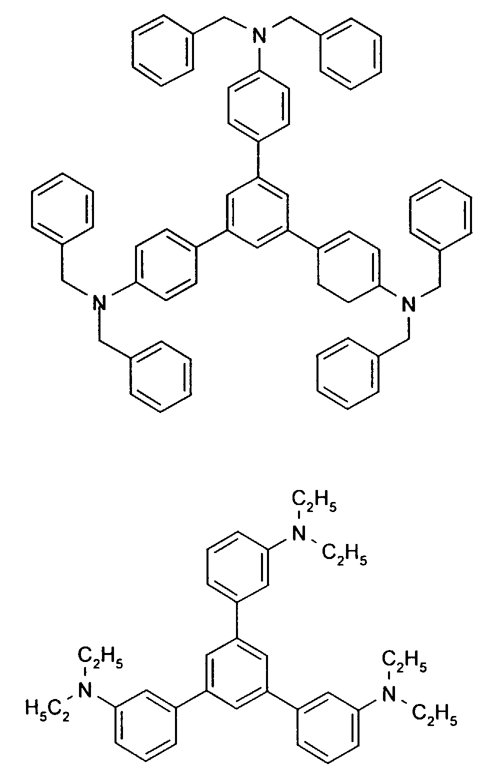

9. Elektrolumineszierende Anordnung gemäß Anspruch 5, dadurch gekennzeichnet, daß der transparente Binder C ausgewählt ist aus der Gruppe Polycarbonate, Polyestercarbonate, Copolymere des Styrols wie SAN oder Styrolacrylate, Polysilfone, Polymerisate auf Basis von Vinylgruppen-haltigen Monomeren, Polyolefine, cyclische Olefincopolymere, Phenoxyharze.

10. Elektrolumineszierende Anordnung gemäß Anspruch 5, dadurch gekennzeichnet, daß der Gewichtsanteil der Summe der Gewichtsanteile von A und B im polymeren Binder im Bereich von 0,2 bis 98 Gew.-% liegt, bezogen auf 100 Gew.-% aus A + B + C, und das Gewichtsverhältnis A:B der Komponenten A und B zwischen 0,05 und 20 liegt.

11. Elektrolumineszierende Anordnung gemäß Anspruch 1, dadurch gekennzeichnet, daß das elektrolumineszierende Element eine weitere ladungstransporierende Substanz aus der Gruppe der loch- und/oder elektronenleitenden Materialien enthält.

12. Elektrolumineszierende Anordnung gemäß Anspruch 1, dadurch gekennzeichnet, daß das elektrolumineszierende Element aus einem Einschichtsystem besteht.

13. Elektrolumineszierende Anordnung gemäß Anspruch 1, dadurch gekennzeichnet, daß das elektrolumineszierende Element nur aus einer Zone besteht, die eine gegebenenfalls substituierte Tris-1,3,5-(aminophenyl)benzolverbindung, Tri-(5-hexanoyl-8-hydroxychinolin)-aluminium und Polyvinylcarbazol enthält.

14. Elektrolumineszierende Anordnung gemäß Anspruch 1, dadurch gekennzeichnet, daß das elektrolumineszierende Element aus mehreren Zonen besteht, wobei eine separate emittierende und elektronenleitende Schicht aus einer Metallkomplexverbindung gemäß Formel (II) besteht.

15. Verwendung der elektrolumineszierenden Anordnung gemäß Anspruch 1 zur Be-/Hinterleuchtung, Informationsdarstellung und zum Aufbau von Segment- oder Matrixanzeigen.
